# EUROPEAN PATENT SPECIFICATION

(11) **EP 3 842 742 B1**
(45) Date of publication and mention of the grant of the patent: **13.09.2023**
(21) Application number: 19866617.4
(22) Date of filing: 25.09.2019
(51) Int. Cl.: G01C 19/5607, H10N 30/00

(54) **SENSOR ELEMENT AND ANGULAR VELOCITY SENSOR**
SENSORELEMENT UND WINKELGESCHWINDIGKEITSSENSOR
ÉLÉMENT DE CAPTEUR ET CAPTEUR DE VITESSE ANGULAIRE

(30) Priority: 28.09.2018 JP 2018184760
(43) Date of publication of application: 30.06.2021
(73) Proprietor: Kyocera Corporation, Kyoto-shi, Kyoto 612-8501 (JP)
(72) Inventor: SOEJIMA, Munetaka, Kyoto-shi, Kyoto 612-8501 (JP); TAKANAMI, Shun, Kyoto-shi, Kyoto 612-8501 (JP)
(74) Representative: Viering, Jentschura & Partner mbB Patent- und Rechtsanwälte
(86) International application number: PCT/JP2019/037633
(87) International publication number: WO 2020/067178

(56) References cited:
- WO-A1-2018/021166
- WO-A1-2018/021166
- JP-A- 2016 130 646
- JP-A- 2016 130 646
- US-A- 5 763 781
- US-A1- 2016 231 110

## Description

### Technical Field

The present disclosure relates to a sensor element utilized for detection of an angular velocity and to an angular velocity sensor having the sensor element.

### Background Art

Known in the art is a so-called piezoelectric vibration type angular velocity sensor (for example Patent Literatures 1 and 2). In this sensor, an AC voltage is supplied to a piezoelectric body to excite the piezoelectric body. When this excited piezoelectric body is rotated, a Coriolis force having a magnitude in accordance with the rotation speed (angular velocity) is generated in a direction perpendicular to the direction of excitation. The piezoelectric body also vibrates by this Coriolis force. Further, by detecting an electrical signal generated in accordance with the deformation of the piezoelectric body due to this Coriolis force, the angular velocity of the piezoelectric body can be detected.

Patent Literatures 1 and 2 propose new modes of vibration in the piezoelectric body of the sensor described above. Specifically, the piezoelectric body has a frame having an x-axis direction in an orthogonal coordinate system xyz as the longitudinal direction, a pair of driving arms which extend from the frame alongside each other in a y-axis direction at positions where they are separated from each other in the x-axis direction, and a detecting arm which extends from the frame in the y-axis direction at the position becoming the center of the pair of driving arms in the x-axis direction. Further, the pair of driving arms are excited so as to bend to opposite sides to each other in the x-axis direction. Due to this, a vibration with bending deformation of the frame in the y-axis direction is generated. In turn, a vibration in which the detecting arm displaces in the y-axis direction is generated. In a case where the sensor is rotated about a z-axis, the detecting arm vibrates in the x-axis direction due to the Coriolis force. When the sensor is rotated about the x-axis, the detecting arm vibrates in the z-axis direction due to the Coriolis force.

### Citation List

### Patent Literature

Patent Literature 1: WO2018/021166
Patent Literature 2: WO2018/021167

Moreover, WO 2018/021166 A1 discloses an angular velocity sensor having a piezoelectric body, a drive circuit, and a detection circuit, the piezoelectric body having a frame, a pair of driving arms and a detection arm; US 2016/231110 A1 discloses a vibrating element including a vibrating arm, wherein an electrode is provided on the vibrating arm for detection; and JP 2016 130646 A discloses a gyro element including: a stem; vibration arms for drive, which extend from the stem and are driven to vibrate; and vibration arms for detection, which also extend from the stem and have electrodes for detection.

### Summary of Invention

The present invention provides a sensor element according to claim 1. Preferred embodiments are described in the dependent claims.

An angular velocity sensor according to one aspect of the present disclosure includes the sensor element described above, a driving circuit supplying an AC voltage to the two excitation-use terminals, and a detection circuit which detects signals from the first detection-use terminal and the second detection-use terminal.

### Brief Description of Drawings

FIG. 1 is a perspective view showing a piezoelectric body of a sensor element according to a first embodiment.
FIG. 2A is a perspective view showing a portion of the sensor element in FIG. 1 in an enlarged manner, and FIG. 2B is a cross-sectional view taken along the IIb-IIb line in FIG. 2A.
FIG. 3A and FIG. 3B are schematic views for explaining vibrations regarding excitation in the sensor element in FIG. 1.
FIG. 4A and FIG. 4B are schematic views for explaining vibrations regarding detection in the sensor element in FIG. 1.
FIG. 5A and FIG. 5B are a top view schematically showing detection-use wirings in the sensor element in FIG. 1 and a bottom view seen through it from an upper part.
FIG. 6A and FIG. 6B are a top view schematically showing detection-use wirings in a sensor element according to a comparative example and a bottom view seen through it from the upper part.
FIG. 7A and FIG. 7B are top views schematically showing detection-use wirings in sensor elements according to second and third embodiments.
FIG. 8 is a top view showing a piezoelectric body of a sensor element according to a fourth embodiment.
FIG. 9A and FIG. 9B are schematic views for explaining vibrations regarding excitation in the sensor element in FIG. 8.
FIG. 10A and FIG. 10B are schematic views for explaining vibrations regarding detection in the sensor element in FIG. 8.
FIG. 11 is a top view schematically showing detection-use wirings in the sensor element in FIG. 8.
FIG. 12 is a bottom view schematically showing the detection-use wirings in the sensor element in FIG. 8 seen through it from the upper part.
FIG. 13 is a top view schematically showing detection-use wirings in a sensor element according to a fifth embodiment.
FIG. 14 is a top view schematically showing detection-use wirings in a sensor element according to a sixth embodiment.
FIG. 15 is a top view schematically showing detection-use wirings in a sensor element according to a seventh embodiment.
FIG. 16 is a top view schematically showing detection-use wirings in a sensor element according to an eighth embodiment.
FIG. 17A is a perspective view showing a portion of a sensor element according to a ninth embodiment in an enlarged manner, and FIG. 17B is a cross-sectional view taken along the XVIIb-XVIIb line in FIG. 17A.
FIG. 18A and FIG. 18B are schematic views for explaining vibrations regarding detection in the sensor element in FIG. 17A.

### Description of Embodiments

For the configurations of the sensor element and angular velocity sensor according to the embodiments in the present disclosure, the ones described in Patent Literatures 1 and 2 can be applied excluding the configuration and action relating to the detection-use wirings.

Below, embodiments according to the present disclosure will be explained with reference to the drawings. The following drawings are schematic ones. Accordingly, sometimes details will be omitted. Further, the size ratios and the like will not always coincide with the actual ones. Further, the size ratios among the plurality of drawings will also not always coincide with each other.

Further, for convenience of explanation, an orthogonal coordinate system xyz is attached to each of the drawings. The orthogonal coordinate system xyz is defined based on the shape of the sensor element (piezoelectric body). That is, the x-axis, y-axis, and z-axis do not always indicate an electrical axis, mechanical axis, and optical axis of a crystal. The sensor element may be used so that any direction is defined as "above" or "below". In the following explanation, however, for convenience, sometimes the "upper surface" or "lower surface" and other terms will be used where the positive side in the z-axis direction is the upper part. Further, when simply referred to as "viewed on a plane", it means "viewed in the z-axis direction" unless particularly explained otherwise.

Further, the same or similar configurations are sometimes assigned additional notations of letters of the alphabet which are different from each other such as with the "driving arm 7A" and "driving arm 7B". Further, in this case, sometimes the configurations will be simply referred to as the "driving arms 7" and will not be differentiated.

In the second and following embodiments, basically only differences from the previously explained embodiments will be explained. The points which are not particularly referred to may be considered the same as the configurations in the previously explained embodiments. Further, for the configurations which are mutually corresponding (same or similar) among the plurality of embodiments, sometimes common notations will be attached even if shapes etc. are different.

### [First Embodiment]

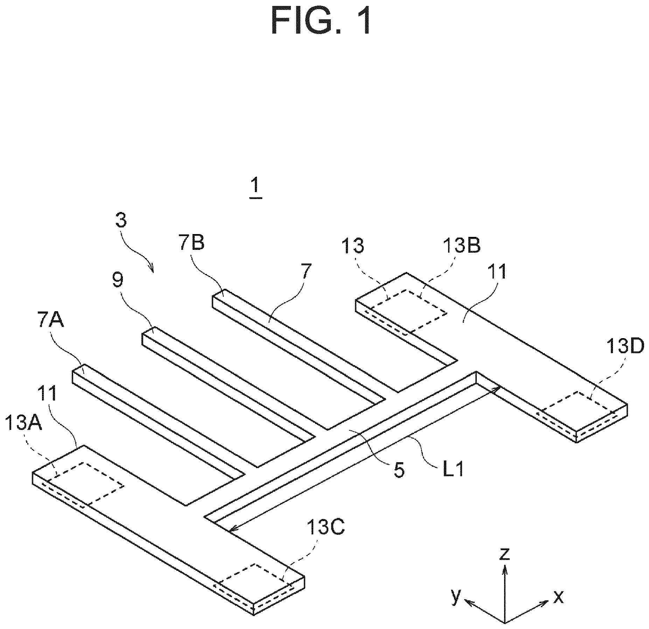

FIG. 1 is a perspective view showing the configuration of a sensor element 1 according to a first embodiment. However, in this view, basically illustration of conductive layers which are provided on the surface of the sensor element 1 is omitted.

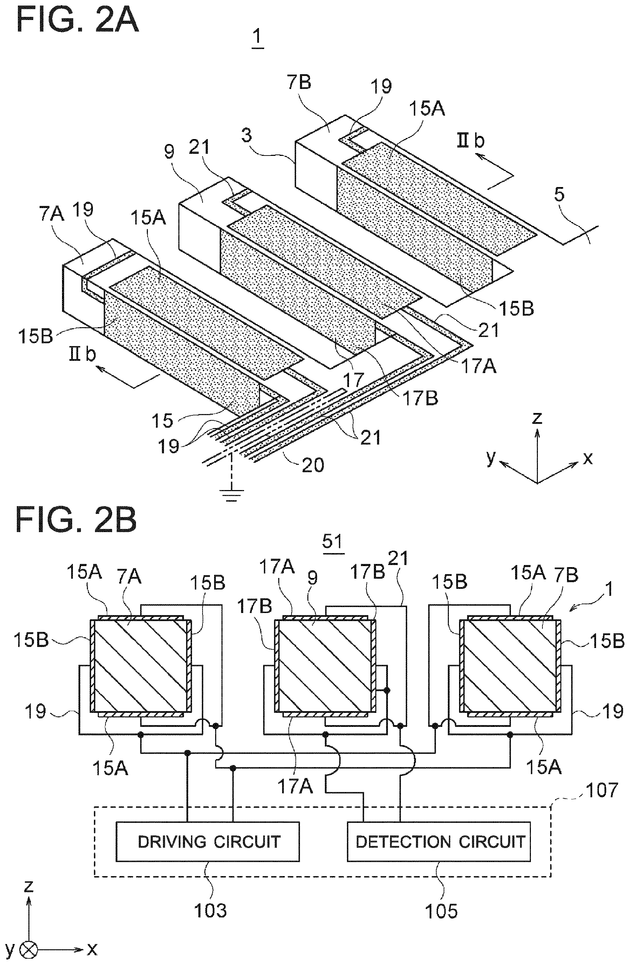

The sensor element 1 for example configures an angular velocity sensor 51 (notation is shown in FIG. 2B) of a piezoelectric vibration type which detects the angular velocity around the z-axis . The sensor element 1 has a piezoelectric body 3. When the piezoelectric body 3 is rotated in a state where voltage is supplied to the piezoelectric body 3 and the piezoelectric body 3 is vibrating, vibration is generated due to a Coriolis force in the piezoelectric body 3. By detecting the electrical signal (for example, voltage or charge) generated due to the vibration by this Coriolis force, the angular velocity is detected. Specifically, this is as follows.

### (Shape of Piezoelectric Body)

The piezoelectric body 3 is for example formed integrally as a whole. The piezoelectric body 3 may be a single crystal or may be a polycrystal. Further, the material for the piezoelectric body 3 may be suitably selected. For example, it is a quartz crystal (SiO₂), LiTaO₃, LiNbO₃, PZT, or silicon.

In the piezoelectric body 3, the electrical axis or polarization axis (below, sometimes only the polarization axis will be referred to as representative of the two) is set so as to coincide with the x-axis. The polarization axis may be inclined relative to the x-axis within a predetermined range (for example 15° or less) as well. Further, in a case where the piezoelectric body 3 is a single crystal, the mechanical axis and optical axis may be made suitable directions. For example, the mechanical axis is made the y-axis direction, and the optical axis is made the z-axis direction.

The piezoelectric body 3 is for example made constant in thickness (z-axis direction) as a whole. Further, the piezoelectric body 3 is substantially formed in a line symmetrical shape relative to a not shown symmetrical axis parallel to the y-axis. However, for example, due to the shape caused by an anisotropy of the piezoelectric body 3 with respect to etching, presence of relief shapes for lowering the probability of short-circuiting of the wirings, or the like, details are not always line symmetrical.

The piezoelectric body 3 for example has a frame 5, two (for example a pair of, below, it will be explained in a case of a pair) driving arms 7 (7A and 7B) and a detecting arm 9 which extend from the frame 5, and two (for example a pair of, below, it will be explained in a case of a pair) mounting arms 11 which support the frame 5.

The pair of driving arms 7 are portions which are excited by supply of voltage (electric field). The detecting arm 9 is a portion which vibrates due to the Coriolis force and generates an electrical signal in accordance with the angular velocity. The frame 5 is the portion which contributes to support of the driving arms 7 and detecting arm 9 and transfer of vibration from the driving arms 7 to the detecting arm 9. The mounting arms 11 are portions contributing to mounting of the sensor element 1 on a not shown mounting base body (for example a portion of a package or circuit board).

The frame 5 for example has a long shape having the x-axis direction as the longitudinal direction as a whole and is arranged bridging the pair of mounting arms 11. The two ends of the frame 5 become supported parts which are supported by the pair of mounting arms 11. The frame 5 becomes able to flexurally deform like a beam supported at its two ends when viewed on a plane.

In the example shown, the frame 5 is given a shape where its entirety linearly extends in the x-axis direction. However, the frame 5 may be given a shape other than this as well. For example, the frame 5 may have bent portions at the two ends as well. In this case, the overall length of the frame 5 becomes longer, therefore the frame 5 becomes easier to flexurally deform.

The various dimensions of the frame 5 may be suitably set. For example, one of the width (y-axis direction) and the thickness (z-axis direction) of the frame 5 may be larger than the other. Further, for example, the frame 5 is designed to flexurally deform when viewed on a plane, therefore the width of the frame 5 may be made relatively small. For example, the width of the frame 5 may be made smaller than the width of the portion provided with terminals 13 which will be explained later (mounting arms 11 in the present embodiment) in the piezoelectric body 3. Further, for example, the length and width of the frame 5 may be adjusted so that a natural frequency of the bending deformation when viewed on a plane becomes closer to the natural frequency of the driving arms 7 in a direction in which they are excited by application of voltage and/or becomes closer to the natural frequency of the detecting arm 9 in a direction of vibration due to the Coriolis force.

A length L1 of the frame 5 may be made for example a length from one end to the other end in the frame 5 (length from one of the two support positions of the frame 5 to the other) . In the example shown, the length L1 is the same as a distance from a +x side side-surface of the -x side mounting arm 11 to a -x side side-surface of the +x side mounting arm 11. In a case where the frame 5 has a bent portion or otherwise where the frame 5 is not straight, for example, the length L1 may be made the length along the route of the frame 5 (in more detail, the center line thereof).

The driving arms 7 extend from the frame 5 in the y-axis direction. Their front ends are made free ends. Accordingly, the driving arms 7 become able to flexurally deform in a cantilever manner. The pair of driving arms 7 extend alongside each other (for example parallel) at positions where they are separated from each other in the x-axis direction. The pair of driving arms 7 are for example provided at line symmetrical positions relative to a not shown symmetrical axis which passes through the center of the frame 5 and is parallel to the y-axis (see the detecting arm 9).

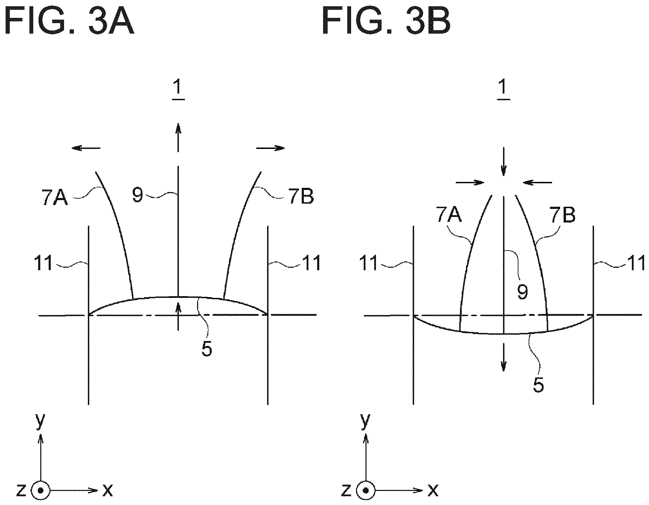

As will be explained later (FIG. 3A and FIG. 3B), the pair of driving arms 7 are intended to make the frame 5 flexurally deform (vibrate) when viewed on a plane by excitation in the x-axis direction. Accordingly, for example, the positions of the pair of driving arms 7 in the x-axis direction relative the frame 5 may be suitably set so that the deflection of the frame 5 becomes large due to vibration of the pair of driving arms 7. For example, when equally dividing the length of the frame 5 in the x-axis direction into three parts, the pair of driving arms 7 are respectively positioned in the regions on the two sides

The specific shapes etc. of the driving arms 7 may be suitably set. For example, the driving arms 7 are made cuboid shapes . That is, the cross-sectional shape (xz plane) is rectangular. Although not particularly shown, the driving arms 7 may be hammer shaped with widths (x-axis direction) becoming broader at the front end side portion as well. The pair of driving arms 7 are for example substantially mutually symmetrically shaped and sized. Accordingly, the vibration characteristics of the two are equal to each other. However, for example, by adjusting the shape of the transverse cross-section (for example providing notches in the rectangles) in order to reduce unwanted vibration, sometimes the shapes of the pair of driving arms 7 become line asymmetrical.

The driving arms 7 are excited in the x-axis direction as will be explained later. Accordingly, in the driving arms 7, the larger the width (x-axis direction), the higher the natural frequency in the excitation direction (x-axis direction). The larger the length (mass from another viewpoint), the lower the natural frequency in the excitation direction. The various dimensions of the driving arms 7 are for example set so that the natural frequency in the excitation direction of the driving arms 7 becomes closer to the intended frequency. In this case, the intended frequency may be set so as to be separated from the unwanted vibration frequency (frequency at which an unwanted vibration occurs in the z-axis direction of the piezoelectric body 3) by 1 kHz or more. This is because loss of balance of the frame operation at the time of excitation of the driving arms 7 can be reduced and unwanted vibration of the detecting arm 9 which will be explained later can be reduced.

The detecting arm 9 extends from the frame 5 in the y-axis direction. Its front end is made a free end. Accordingly, the detecting arm 9 becomes able to flexurally deform in a cantilever manner. Further, the detecting arm 9 extends between the pair of driving arms 7 alongside (for example in parallel with) the pair of driving arms 7. The detecting arm 9 is for example positioned at the center in the x-axis direction of the frame 5 and/or positioned at the center between the pair of driving arms 7.

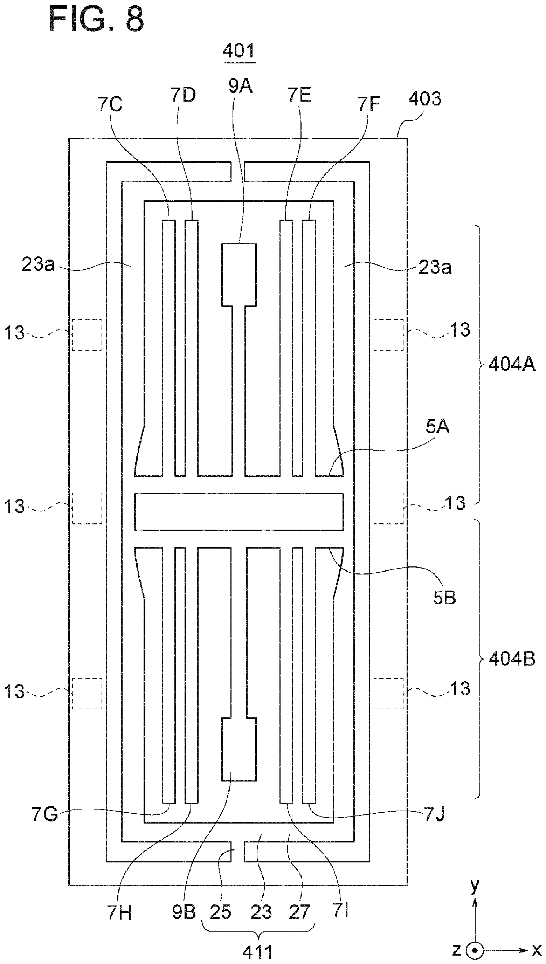

The specific shape etc. of the detecting arm 9 may be suitably set. For example, the detecting arm 9 is made a long cuboid shape. That is, the cross-sectional shape (xz plane) is rectangular. The detecting arm 9 may be hammer shaped with a width (x-axis direction) becoming broader at the front end side portion as well (see detecting arms 9A and 9B in FIG. 8 which will be explained later) .

The detecting arm 9, as will be explained later, in the present embodiment, vibrates in the x-axis direction due to the Coriolis force. Accordingly, in the detecting arm 9, the larger the width (x-axis direction), the higher the natural frequency in the vibration direction (x-axis direction). The larger the length (mass from another viewpoint), the lower the natural frequency in the vibration direction. The various dimensions of the detecting arm 9 are for example set so that the natural frequency of the detecting arm 9 in the vibration direction becomes close to the natural frequency of the driving arms 7 in the excitation direction. The length of the detecting arm 9 is for example equal to the lengths of the driving arms 7. However, the two may be different as well.

The pair of mounting arms 11 are for example formed in shapes having the y-axis direction as the longitudinal directions. In the example shown, in the mounting arms 11, the shapes of the transverse cross-sections (xz cross-sections) are made constant in the longitudinal direction (y-axis direction) . However, in the mounting arms 11, the shapes of the transverse cross-sections may change in the longitudinal direction for example the widths are made narrow in the connection portions with the frame 5 as well. The various dimensions of the mounting arms 11 may be suitably set.

### (Terminals)

On the bottom surfaces of the pair of mounting arms 11, at least four terminals 13 (13A to 13D) are provided. The terminals 13 face the pads provided on a not shown mounting base body and are bonded with respect to the pads on the mounting base body by bumps made of solder or conductive adhesive. Due to this, electrical connection between the sensor element 1 and the mounting base body is made. Further, the sensor element 1 (piezoelectric body 3) is supported in a state where the driving arms 7 and the detecting arm 9 can vibrate. The four terminals 13 are for example provided at the two ends of the pair of mounting arms 11.

### (Excitation Electrodes and Detecting Electrodes)

FIG. 2A is a perspective view showing a portion of the sensor element 1 in an enlarged manner. Further, FIG. 2B is a cross-sectional view taken along the IIb-IIb line in FIG. 2A.

The sensor element 1 has excitation electrodes 15 (15A and 15B) for supplying voltages to the driving arms 7 and detecting electrodes 17 (17A and 17B) for extracting signals generated in the detecting arm 9. They are configured by conductive layers formed on the surface of the piezoelectric body 3. The material for the conductive layers is for example Cu, Al, or another metal.

The additional notations "A" and "B" of the excitation electrodes 15 and detecting electrodes 17 are attached based on the orthogonal coordinate system xyz. Accordingly, as will be explained later, the excitation electrode 15A on one driving arm 7 and the excitation electrode 15A on the other driving arm 7 do not always have the same potential. The same is true for the excitation electrodes 15B. In an aspect where a plurality of detecting arms 9 are provided (embodiments which will be explained later), the same is true for the detecting electrodes 17A and 17B.

The excitation electrodes 15A at the driving arms 7 are provided at the respective upper surfaces and lower surfaces (for example pairs of surfaces facing the two sides in the z-axis direction). Further, the excitation electrodes 15B at the driving arms 7 are for example provided at the respective pairs of side surfaces (pairs of surfaces facing the two sides in the x-axis direction).

In the embodiments which will be explained later, sometimes provision is made of driving arms 7 which extend from the frame 5 toward the negative side in the y-axis direction. In such driving arms 7 as well, the additional notations "A" of the excitation electrodes 15 correspond to the upper surfaces and lower surfaces, and the additional notations "B" of the excitation electrodes 15 correspond to the side surfaces.

On the upper, lower, left, and right surfaces of each of the driving arms 7, the excitation electrodes 15 are for example formed so as to cover majorities of the surfaces. However, at least one of each two excitation electrodes 15A and 15B (excitation electrodes 15A in the present embodiment) is formed smaller in the width direction than the surface so that the electrodes are not short-circuited with each other. Further, parts of the root sides and front end sides of the driving arms 7 may be made positions where no excitation electrodes 15 are arranged.

In each of the driving arms 7, the two excitation electrodes 15A are for example rendered the same potentials as each other. Further, at each of the driving arms 7, the two excitation electrodes 15B are for example rendered the same potentials as each other. The excitation electrodes 15 which should be rendered the same potentials are for example connected with each other.

If voltage is supplied between the excitation electrodes 15A and the excitation electrodes 15B, for example, in the driving arm 7, an electric field heading from the upper surface toward the pair of side surfaces (two sides in the x-axis direction) and an electric field heading from the lower surface toward the pair of side surfaces are generated. On the other hand, the polarization axis matches with the x-axis direction. Accordingly, when focusing on the components in the x-axis direction of the electric fields, in the driving arm 7, the direction of the electric field and the direction of the polarization axis match in one side portion of the x-axis direction, while the direction of the electric field and the direction of the polarization axis become inverse to each other in the other side portion.

As a result, the one side portion of the driving arm 7 in the x-direction contract in the y-axis direction, and the other side portion extend in the y-axis direction. Further, the driving arm 7 flexes to one side in the x-direction like a bimetal. If voltages supplied to the excitation electrodes 15A and 15B are inverted, the driving arm 7 flexes to an inverse direction. According to such a principle, if an AC voltage is supplied to the excitation electrodes 15A and 15B, the driving arm 7 vibrates in the x-axis direction.

Although particularly not shown, one or more recessed grooves extending along the longitudinal direction of the driving arm 7 (the recessed groove may be configured by a plurality of concave portions arranged in the longitudinal direction of the driving arm 7 as well) may be provided in the upper surface and/or lower surface of the driving arm 7, and the excitation electrodes 15A may be provided over the interiors of these recessed grooves. In this case, the excitation electrodes 15A and the excitation electrodes 15B face in the x-axis direction while sandwiching the wall portions of the recessed grooves therebetween, therefore the efficiency of excitation is improved.

In the pair of driving arms 7, the excitation electrodes 15A on the driving arm 7A and the excitation electrodes 15B on the driving arm 7B are rendered the same potential, and the excitation electrodes 15B on the driving arm 7A and the excitation electrodes 15A on the driving arm 7B are rendered the same potential. The excitation electrodes 15 which must be rendered the same potential are for example connected with each other.

If applying AC voltage between the excitation electrodes 15A and the excitation electrodes 15B in such connection relationships, voltages having inverse phases from each other are supplied to the pair of driving arms 7, therefore the arms vibrate so as to flexurally deform in reverse directions to each other in the x-axis direction.

The detecting electrodes 17, in the present embodiment, are given the same configurations as those of the excitation electrodes 15. That is, the detecting electrodes 17A in the detecting arm 9 are provided on each of the upper surface and lower surface (for example a pair of surfaces facing the two sides in the z-axis direction). Further, the detecting electrodes 17B in the detecting arm are provided on each of the pair of side surfaces (for example a pair of surfaces facing the two sides in the x-axis direction). The two detecting electrodes 17A are connected with each other. Further, the two detecting electrodes 17B are connected with each other.

In the same way as the excitation electrodes 15, also in the detecting electrodes 17, the additional notation A corresponds to the upper surface and lower surface, and the additional notation B corresponds to the side surfaces. The explanations for the sizes and arrangement positions in the driving arms 7 of the excitation electrodes 15 explained above may be applied to the sizes and positions of arrangement in the detecting arm 9 of the detecting electrodes 17. Further, also in the detecting arm 9, a recessed groove may be formed in the upper surface and/or lower surface.

If the detecting arm 9 flexurally deforms in the x-axis direction, due to a principle inverse to the excitations of the driving arms 7, voltages are generated between the detecting electrodes 17A and the detecting electrodes 17B. In other words, the detecting electrodes 17A and 17B extract mutually different positive or negative (polarity) charges (from another viewpoint, potentials or signals) from the detecting arm 9. When the detecting arm 9 vibrates in the z-axis direction, the voltages given to the detecting electrodes 17 are detected as the AC voltage.

### (Wiring Parts (Outline))

The sensor element 1 has a plurality of excitation-use wiring parts 19 which connect at least two among the plurality of terminals 13 (two among the four terminals 13 in the present embodiment) and the plurality of excitation electrodes 15 to each other and has a plurality of detection-use wiring parts 21 which connect at least the other two among the plurality of terminals 13 (two among the four in the present embodiment) and the plurality of detecting electrodes 17 to each other.

In more detail, part of the plurality of excitation-use wiring parts 19 connect the plurality of excitation electrodes 15A and one of the four terminals 13 to each other. Further, the remaining parts of the plurality of excitation-use wiring parts 19 connect the plurality of excitation electrodes 15B and another one among the four terminals 13 to each other. Part of the plurality of detection-use wiring parts 21 connect the plurality of detecting electrodes 17A and still another among the four terminals 13 to each other. Further, the remaining parts of the plurality of detection-use wiring parts 21 connect the plurality of detecting electrodes 17B and the remaining one of the four terminals 13 to each other.

The plurality of excitation-use wiring parts 19 and plurality of detection-use wiring parts 21 are configured by conductive layers formed on the surface of the piezoelectric body 3. The material for the conductive layers is for example Cu, Al, or another metal. Further, these wiring parts may be configured by the same materials as those for the excitation electrodes 15 and detecting electrodes 17.

The plurality of excitation-use wiring parts 19 and the plurality of detection-use wiring parts 21 can realize the connections explained above without short-circuiting with each other in a mode where the entireties thereof are provided on the surface of the piezoelectric body 3 by being suitably arranged on the upper surfaces, lower surfaces, and/or side surfaces of various parts in the piezoelectric body 3. However, a three-dimensional intersecting part may be formed as well by providing an insulation layer on the wiring parts positioned on the piezoelectric body 3 and providing another wiring part on that.

Further, the piezoelectric body 3 may be provided with one or more terminals 13 for reference potential use which are given the reference potential from an external portion and with a reference potential wiring 20 (indicated by a two-dotted chain line in FIG. 2A) which is connected to the reference potential-use terminals 13. The reference potential-use terminals 13 are not shown terminals which are different from the above four terminals 13 which are connected to the excitation-use wiring parts 19 and detection-use wiring parts 21. For example, the reference potential-use terminals 13 may be provided at suitable positions on the lower surfaces of the mounting arms 11 as well.

The reference potential wiring 20, for example, has a portion which is positioned between the excitation-use wiring part 19 and the detection-use wiring part 21. More specifically, for example, a portion of the reference potential wiring 20 extends on the upper surface and/or lower surface of the frame 5 along (for example parallel to) the longitudinal direction of the frame 5 between one or more (two in the example shown) excitation-use wiring parts 19 and one or more (two in the example shown) detection-use wiring parts 21.

By providing the reference potential wiring 20 between the excitation-use wiring part 19 and the detection-use wiring part 21, for example, the reference potential wiring 20 functions as a shield, therefore the influence of the driving signal flowing through the excitation-use wiring part 19 exhibited upon the detection signal flowing through the detection-use wiring part 21 can be reduced. As a result, the detection accuracy is improved. From another viewpoint, the excitation-use wiring part 19 and the detection-use wiring part 21 can be arranged close to each other.

### (Driving Circuit and Detecting Circuit)

As shown in FIG. 2B, the angular velocity sensor 51 has a driving circuit 103 supplying voltage to the excitation electrodes 15 and a detecting circuit 105 detecting the electrical signals from the detecting electrodes 17.

### The driving circuit 103 is for example configured

including an oscillation circuit or amplifier and supplies an AC voltage having a predetermined frequency between the excitation electrodes 15A and the excitation electrodes 15B through the two terminals 13. The frequency may be determined in advance in the angular velocity sensor 51 or may be designated from an external apparatus or the like.

The detecting circuit 105, for example, is configured including an amplifier and wave detecting circuit, detects a potential difference between the detecting electrode 17A and the detecting electrode 17B through the two terminals 13, and outputs an electrical signal in accordance with the detection result to an external apparatus or the like. More specifically, for example, the potential difference described above is detected as the AC voltage, and the detecting circuit 105 outputs a signal in accordance with the amplitude of the detected AC voltage. The angular velocity is identified based on this amplitude. Further, the detecting circuit 105 outputs a signal in accordance with a phase difference between the applied voltage of the driving circuit 103 and the electrical signal which was detected. The direction of rotation is identified based on this phase difference.

The driving circuit 103 and detecting circuit 105 configure a control circuit 107 as a whole. The control circuit 107 is for example configured by a chip IC (integrated circuit) and is mounted on a circuit board on which the sensor element 1 is mounted or a mounting base body having a suitable shape.

### (Operation of Angular Velocity Sensor)

FIG. 3A and FIG. 3B are schematic plan views for explaining excitation of the piezoelectric body 3. In the two views, phases of the AC voltages supplied to the excitation electrodes 15 are offset by 180° from each other.

As explained above, the driving arms 7A and 7B are excited with inverse phases to each other so that they bend in inverse directions from each other in the x-axis direction by application of the AC voltages to the excitation electrodes 15. At this time, as shown in FIG. 3A, if the pair of driving arms 7 flex to the outer sides in the x-axis direction relative to each other (sides for mutual separation of the pair of driving arms 7), the bending moment is transferred to the frame 5, therefore the frame 5 flexes to the positive side in the y-axis direction. As a result, the detecting arm 9 displaces to the positive side in the y-axis direction. Conversely, as shown in FIG. 3B, if the pair of driving arms 7 flex to the inner sides in the x-axis direction relative to each other (sides for mutual approach of the pair of driving arms 7), the bending moment is transferred to the frame 5, therefore the frame 5 flexes to the negative side in the y-axis direction. As a result, the detecting arm 9 displaces to the negative side in the y-axis direction. Accordingly, by excitations of the pair of driving arms 7, the detecting arm 9 vibrates in the y-axis direction.

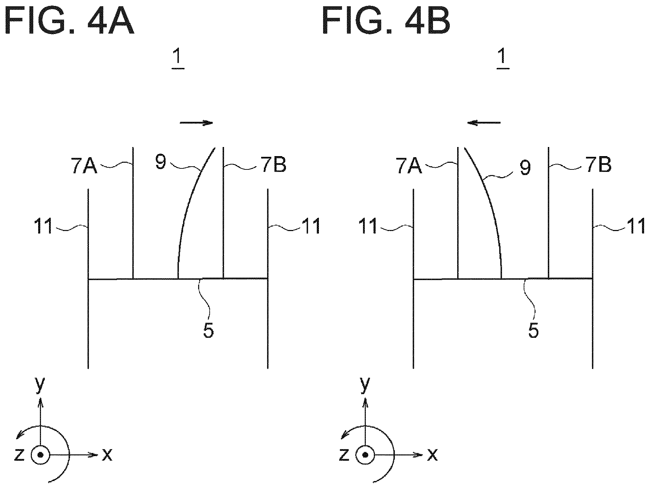

FIG. 4A and FIG. 4B are schematic perspective views for explaining vibration of the detecting arm 9 due to the Coriolis force. FIG. 4A and FIG. 4B correspond to the states in FIG. 3A and FIG. 3B. In these views, illustrations of deformations of the driving arms 7 and frame 5 are omitted.

As explained with reference to FIG. 3A and FIG. 3B, assumed that the piezoelectric body 3 is vibrating. In this state, when the sensor element 1 is rotated about the z-axis, the detecting arm 9 is vibrating (displacing) in the y-axis direction, therefore it vibrates (deforms) in the direction (x-axis direction) which is perpendicular to the rotation axis (z-axis) and the vibration direction (y-axis) due to the Coriolis force. The signal (for example voltage) generated due to this deformation is extracted by the detecting electrodes 17 as explained above. The larger the angular velocity, the larger the Coriolis force (in turn, the voltage of the signal detected) . Due to this, the angular velocity is detected.

### (Detection-Use Wiring Parts)

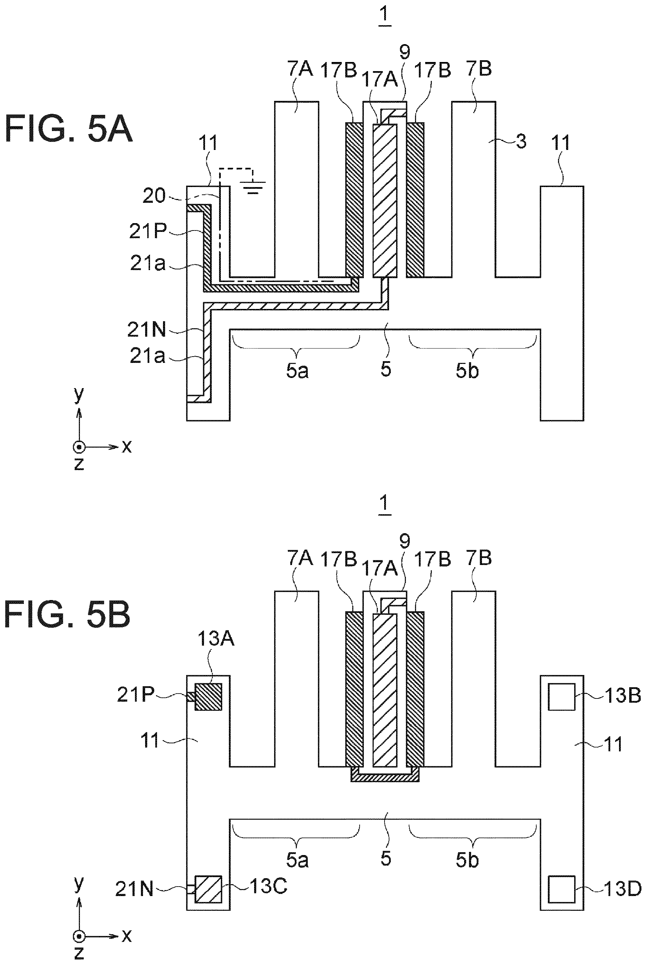

FIG. 5A is a top view (view showing the surface on the +z side) schematically showing the detection-use wiring parts 21. FIG. 5B is a bottom view (view showing the surface on the -z side) schematically showing the detection-use wiring parts 21. However, FIG. 5B shows the bottom surface of the sensor element 1 seen through the sensor element 1 from the upper part (+z side).

These views schematically show the piezoelectric body 3, detecting electrodes 17, detection-use wiring parts 21, and terminals 13. As already explained, the detecting electrodes 17, detection-use wiring parts 21, and the terminals 13 which are connected to the detection-use wiring parts 21 are divided into two sets from a viewpoint of the potentials. The combinations of mutually different potentials are given mutually different hatchings.

Further, in FIG. 5A, an example of the position of at least a portion of the reference potential wiring 20 in the case where it is provided is indicated by a two-dotted chain line. On the side of the reference potential wiring 20 opposite to the detection-use wiring parts 21, the excitation-use wiring parts 19 which are not shown here may be positioned. The same is true for the other drawings corresponding to FIG. 5A in the other embodiments which will be explained later.

Between the two or more detection-use wiring parts 21, one corresponding to one potential will be called a "first wiring part 21P". Between the two or more detection-use wiring parts 21, one corresponding to the other potential will be called a "second wiring part 21N". The first wiring part 21P for example includes a detection-use wiring part 21 which connects the detecting electrodes 17 and the terminal 13 and a detection-use wiring part 21 which connects the detecting electrodes 17 to each other. In other words, the first wiring part 21P includes a plurality of portions which are divided by the detecting electrodes 17. The same is true for the second wiring part 21N.

Further, in the frame 5, the portion closer to one side (-x side) in the longitudinal direction of the frame 5 than the detecting arm 9 will be called a "first portion 5a". In the frame 5, the portion closer to the other side (+x side) in the longitudinal direction of the frame 5 than the detecting arm 9 will be called a "second portion 5b". The configurations of the first portion 5a and the second portion 5b are substantially line symmetrical relative to the detecting arm 9.

As already explained, the detecting electrodes 17A are connected to each other, and the detecting electrodes 17B are connected to each other. In the example shown, the detecting electrodes 17A are connected to each other by the portion in the second wiring part 21N which is positioned at the front end of the detecting arm 9. The detecting electrodes 17B are connected to each other by the portion in the first wiring part 21P which is positioned at the periphery of the root of the detecting arm 9. The position relationships of the detection-use wiring parts 21 connecting the detecting electrodes 17 to each other relative to the detecting arm 9 (whether the front end side or the root side) may be inverse to those in the example shown as well.

The first wiring part 21P has a portion which extends along the frame 5 from the vicinity of the root of the detecting arm 9 toward one side (-x side) in the longitudinal direction of the frame 5. In the same way, the second wiring part 21N has a portion which extends along the frame 5 from the vicinity of the root of the detecting arm 9 toward the one side (-x side) in the longitudinal direction of the frame 5. That is, the first wiring part 21P and the second wiring part 21N extend to the same sides as each other relative to the detecting arm 9 in the frame 5. The same side may be the +x side inverse to that in the example shown as well. From another viewpoint, at least parts of the two wiring parts extend on the frame 5 alongside each other in the longitudinal direction of the frame 5. The length of the extension alongside each other is a length which is somewhat shorter than a half of the length of the frame 5 in the example shown. In other words, it is a length not less than 1/4 of the length of the frame 5. The first wiring part 21P and the second wiring part 21N extend up to the end part of the frame 5 and then extend on the mounting arm 11 and are connected to the terminals 13A and 13C.

The shapes, widths, etc. in the first portions 5a (or second portions 5, the same is true for the following explanation) of the first wiring part 21P and the second wiring part 21N may be suitably set. For example, the first wiring part 21P and the second wiring part 21N linearly extend over the whole length or 80% or more of the first portion 5a with constant widths. Further, the widths in the first portion 5a are the same between the first wiring part 21P and the second wiring part 21N. However, the first wiring part 21P and the second wiring part 21N may bend or may change in widths in the process of extension in the first portion 5a in the longitudinal direction thereof or may be different in widths from each other.

As explained above, in the present embodiment, the sensor element 1 has the piezoelectric body 3, a plurality of excitation electrodes 15, a plurality of detecting electrodes 17, a plurality of terminals 13, a plurality of excitation-use wiring parts 19, and first and second detection-use wiring parts (the first wiring part 21P and second wiring part 21N) . The piezoelectric body 3 has the frame 5, a pair of driving arms 7, and a detecting arm 9. The frame 5 has the x-axis direction in the orthogonal coordinate system xyz as the longitudinal direction. The pair of driving arms 7 extend from the frame 5 alongside each other in the y-axis direction at positions where they are separated from each other in the x-axis direction. The detecting arm 9 extends from the frame 5 in the y-axis direction at the position which becomes the center of the pair of driving arms 7 in the x-axis direction. The plurality of excitation electrodes 15 are positioned on the pair of driving arms 7 with arrangements exciting the pair of driving arms 7 in the x-axis direction. The detecting electrodes 17A and 17B are positioned on the detecting arm 9 in arrangements by which they extract mutually different polarity charges when the detecting arm 9 vibrates in the x-axis direction or z-axis direction (x-axis direction in the present embodiment) . The plurality of excitation-use wiring parts 19 connect the pluralities of excitation electrodes 15 and two excitation-use terminals (13B and 13D in FIG. 5B) in connection relationships by which the pair of driving arms 7 bend to inverse sides to each other in the x-axis direction and vibrate with inverse phases to each other when an AC voltage is supplied to the two terminals 13B and 13D. The first wiring part 21P is connected to one or more first detecting electrodes (detecting electrodes 17B in the example shown) and the first detection-use terminal (terminal 13A in the example shown). The second wiring part 21N is connected to one or more second detecting electrodes (detecting electrodes 17A in the example shown) and the second detection-use terminal (terminal 13C in the example shown). At least a portion of the first wiring part 21P and at least a portion of the second wiring part 21N extend on the frame 5 (on the first portion 5a) alongside each other over the length not less than 1/4 of the length of the frame 5 in the longitudinal direction of the frame 5.

Accordingly, for example, the detection accuracy can be improved. Specifically, this is as follows.

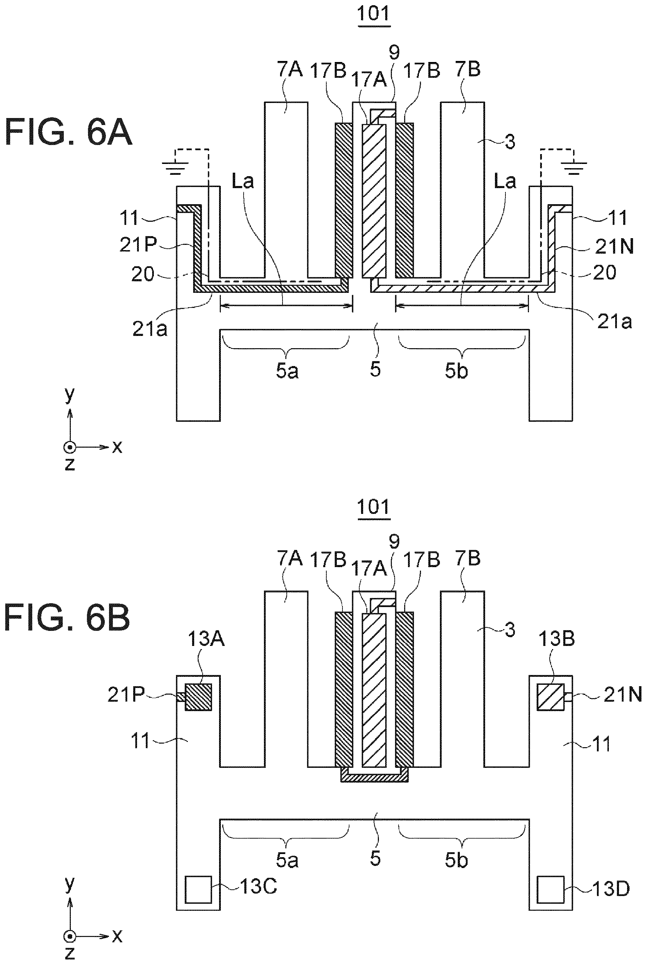

FIG. 6A and FIG. 6B are views corresponding to FIG. 5A and FIG. 5B which schematically show the detection-use wiring parts 21 in a sensor element 101 according to a comparative example.

In the sensor element 101, unlike the embodiment, the first wiring part 21P and the second wiring part 21N extend in the frame 5 to opposite sides to each other relative to the detecting arm 9. Along with this difference, the terminal 13 connected to the second wiring part 21N is also different from that in the embodiment. Although not particularly shown, the arrangements of the excitation-use wiring parts 19 and the terminal 13 connected to the excitation-use wiring parts 19 are different from those in the embodiment.

In the sensor element 101, in the same way as the sensor element 1 in the embodiment, the frame 5 flexurally deforms in the y-axis direction. Along with this flexural deformation, charges are generated on the upper surface of the frame 5. These charges are different in polarity and/or magnitudes from each other between the first portion 5a and the second portion 5b. For example, in a case as in the present embodiment where the sensor element 1 is configured so that the pair of driving arms 7 are line symmetrically driven in the x-axis direction, substantially the charges generated in the first portion 5a and the second portion 5b are inverse to each other in polarity, and have substantially equal magnitudes (absolute values) in many cases. In the following explanation as well, this case will be taken as an example.

Further, the charge generated in the first portion 5a is given to the first wiring part 21P positioned in the first portion 5a. The charge generated in the second portion 5b is given to the second wiring part 21N positioned in the second portion 5b. Accordingly, voltages are supplied from the frame 5 to the first wiring part 21P and the second wiring part 21N.

As a result, the voltage between the two terminals 13 (13A and 13B in FIG. 6B) connected to the first wiring part 21P and the second wiring part 21N becomes one obtained by superposition of the voltage supplied from the frame 5 to the wiring part with the voltage detected by the detecting electrodes 17. Due to this, the voltage between the two terminals 13 becomes one which is larger or smaller than the voltage which should be detected. That is, noise is mixed into the detection signal from the detecting electrodes 17, therefore the detection accuracy of the sensor element 1 falls.

On the other hand, in the sensor element 1 according to the embodiment, both of the first wiring part 21P and second wiring part 21N are positioned in the first portion 5a and are not positioned in the second portion 5b. Accordingly, the charges given from the frame 5 to the two wiring parts are the same in polarity. Further, due to these charges, the potentials in the two wiring parts rise together or fall together. That is, voltages supplied to the two wiring parts due to the charges generated in the frame 5 are not generated or are reduced compared with comparative example. As a result, noise mixed into the detection signal from the detecting electrodes 17 is reduced, therefore the detection accuracy of the sensor element 1 is improved.

For parts of the configuration and effects of the first embodiment, explanation in comparison with the second embodiment is easier to understand than comparison with a comparative example. Accordingly, in the explanation of the second embodiment which will be given later, the configuration and effects of the first embodiment will be supplemented.

In the embodiment, the first wiring part 21P and the second wiring part 21N were positioned on only the upper surface between the upper surface and the lower surface of the frame 5. However, the two wiring parts may be positioned on the lower surface of the frame 5 as well. Further, the polarities of the potentials generated on the upper surface and the lower surface are the same in many cases. Accordingly, at least parts of the two wiring parts may be partially arranged on the upper surface and lower surface as well. The same is true for the embodiments which will be explained later.

At the periphery of the root of the detecting arm 9, due to the complexity of the detection-use wiring parts 21, sometimes the first wiring part 21P and the second wiring part 21N may unintentionally run alongside each other along the longitudinal direction of the frame 5. However, such parallel running on only the periphery of the root of the detecting arm 9 is considered not to extend over 1/4 or more of the length of the frame 5.

In the above first embodiment, the detecting electrodes 17B are one example of the first (or second) detecting electrodes. The detecting electrodes 17A are one example of the second (or first) detecting electrodes. The first wiring part 21P is one example of the first (or second) detection-use wiring part. The second wiring part 21N is one example of the second (or first) detection-use wiring part. The terminal 13A is one example of the first (or second) detection-use terminal. The terminal 13C is one example of the second (or first) detection-use terminal. The terminals 13B and 13D are one example of the excitation-use terminals.

### [Second Embodiment]

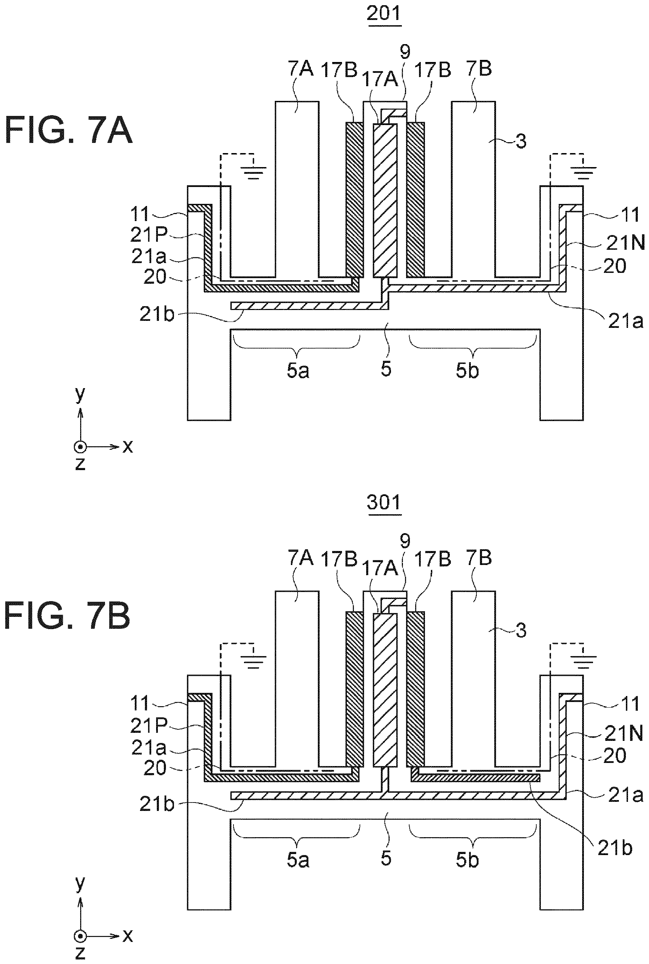

FIG. 7A is a view (top view) corresponding to FIG. 5A which schematically shows the detection-use wiring parts 21 in a sensor element 201 according to a second embodiment. The bottom view of the sensor element 201 is the same as FIG. 6B relating to a comparative example.

The sensor element 201 is changed in configuration of the second wiring part 21N from the sensor element 101 according to the comparative example. Specifically, the second wiring part 21N is given a configuration in which an adjustment-use wiring 21b is added to the wiring body 21a corresponding to the second wiring part 21N in the sensor element 101.

The wiring body 21a is a portion in the second wiring part 21N (or first wiring part 21P) which is connected at one end to the detecting electrode 17 and is connected at the other end to the other detecting electrode 17 or terminal 13. That is, the wiring body 21a configures a transfer route of the detection signal from the detecting electrode 17 to the detection circuit 105. On the other hand, the adjustment-use wiring part 21b is a portion in the second wiring part 21N (or first wiring part 21P) which is directly or indirectly connected at one end to the detecting electrode 17 and is formed as an open end at the other end. That is, the adjustment-use wiring 21b does not directly configure the transfer route of the detection signal from the detecting electrode 17 to the detection circuit 105.

As will be understood from various embodiments which will be explained later, in each of the first wiring part 21P and second wiring part 21N, a plurality of wiring bodies 21a may be provided, and a plurality of adjustment-use wirings 21b may be provided as well. Parts of the plurality of wiring bodies 21a may be shared as well. One end of the adjustment-use wiring 21b may be directly connected to the detecting electrode 17 or may be connected through the wiring body 21a or terminal 13 to the detecting electrode 17. Depending on the mode of winding of the wiring and the like, even if the wiring body 21a seems to extend from the middle of the adjustment-use wiring 21b, the portion from the detecting electrodes 17 to the terminal 13 is the wiring body 21a. Further, the other end of the adjustment-use wiring 21b being formed as an open end means that, in other words, that other end is not connected to the terminal 13 etc.

In the wiring body 21a of the second wiring part 21N, in the same way as the comparative example, the direction of extension from the periphery of the root of the detecting arm 9 in the longitudinal direction of the frame 5 becomes inverse to the direction in the first wiring part 21P (its wiring body 21a). On the other hand, in the adjustment-use wiring 21b in the second wiring part 21N, the direction of extension from the periphery of the root of the detecting arm 9 in the longitudinal direction of the frame 5 becomes the same direction as that of the first wiring part 21P. In other words, both of the wiring body 21a in the first wiring part 21P and the adjustment-use wiring 21b in the second wiring part 21N are positioned in the first portion 5a.

The shape, dimensions, etc. of the adjustment-use wiring 21b may be suitably set. For example, the adjustment-use wiring 21b linearly extends with a constant width over the whole length or 80% or more of the length of the first portion 5a. Further, the width in the first portion 5a of the adjustment-use wiring 21b is for example the same as the width of the wiring body 21a in the first wiring part 21P and/or second wiring part 21N. However, the adjustment-use wiring 21b may be less than 80% of the whole length of the first portion 5a, may bend or may change in width in the process of extension in the first portion 5a in the longitudinal direction of 5a, or the width may be different from the width of the first wiring part 21P and/or second wiring part 21N. Further, the adjustment-use wiring 21b may extend so as to be turned back in the frame 5 or mounting arm 11 etc.

Conversely to the example shown, the second wiring part 21N does not have the adjustment-use wiring 21b in the first portion 5a, but the first wiring part 21P may have the adjustment-use wiring 21b in the second portion 5b.

According to the above configuration as well, the effect of reducing the influence of the charges generated in the frame 5 as explained above can be obtained. Specifically, in the second wiring part 21N in the present embodiment, the charge given to the wiring body 21a positioned in the second portion 5b and the charge given to the adjustment-use wiring 21b positioned in the first portion 5a inverse polarities to each other. As a result, at least parts of the two charges are cancelled in the second wiring part 21N. For example, when assuming that all charges are cancelled in the second wiring part 21N, the voltage between the first wiring part 21P and the second wiring part 21N is generated according to only the charge given to the first wiring part 21P. On the other hand, in the comparative example, as already explained, voltages are supplied to the two wiring parts according to the charges which are given to the first wiring part 21P and the second wiring part 21N and are different in polarity from each other. Accordingly, in the present embodiment, compared with the comparative example, voltages (noise) supplied to the first wiring part 21P and the second wiring part 21N due to the flexural deformation of the frame 5 are reduced.

The effects described above will be further studied by laying out certain assumptions for simplifying the explanation. As shown in FIG. 6A, the length in the longitudinal direction of each of the first portion 5a and second portion 5b is defined as La. Assume that also the lengths of extensions of the first wiring part 21P and the second wiring part 21N in the first portion 5a or second portion 5b are defined as La in the same way. Assume that the charges generated in the first portion 5a and second portion 5b are inverse in polarity to each other and have the same magnitudes as each other. Assume that charges having the same magnitudes (absolute values) are given so far as the lengths of the detection-use wiring parts 21 extending in the x-axis direction in the first portion 5a or the second portion 5b are the same. In the following various explanations, for convenience, sometimes accuracy will be ignored and explanations will be given under these assumptions.

If assumptions are made as described above, the magnitude of the difference of the generated charges between the first wiring part 21P and the second wiring part 21N can be identified from comparison of the lengths of the two wiring parts in the first portion 5a and second portion 5b, and can be substituted with the length La. For example, consider a first length LP obtained by subtracting the length in the second portion 5b from the length in the first portion 5a for the first wiring part 21P and a second length LN obtained by subtracting the length in the second portion 5b from the length in the first portion 5a for the second wiring part 21N. If the difference between LP and LN is 0, there is no difference in the given charges between the first wiring part 21P and the second wiring part 21N, therefore no voltage (noise) arises between the two. The larger the absolute value of the difference between LP and LN, the larger the voltage generated between the two wiring parts.

For example, in the comparative example (FIG. 6A), for the first wiring part 21P, the length LP obtained by subtracting the length (0) in the second portion 5b from the length (La) in the first portion 5a is La. For the second wiring part 21N, the length LP obtained by subtracting the length (La) in the second portion 5b from the length (0) in the first portion 5a is -La. Accordingly, the difference between the lengths LP and LN becomes (La-(-La))=2La.

Further, for example, in the first embodiment (FIG. 5A), for the first wiring part 21P, the length LP obtained by subtracting the length (0) in the second portion 5b from the length (La) in the first portion 5a is La. For the second wiring part 21N, the length LP obtained by subtracting the length (0) in the second portion 5b from the length (La) in the first portion 5a is La. Accordingly, the difference between the lengths LP and LN becomes (La-La)=0.

Further, for example, in the second embodiment (FIG. 7A), for the first wiring part 21P, the length LP obtained by subtracting the length (0) in the second portion 5b from the length (La) in the first portion 5a is La. For the second wiring part 21N, the length LP obtained by subtracting the length (length La of the adjustment-use wiring 21b) in the second portion 5b from the length (length La of the wiring body 21a) in the first portion 5a is 0. Accordingly, the difference between the lengths LP and LN becomes La-0=La.

Accordingly, under the above assumptions, in the first embodiment, all of the voltages (noise) given from the frame 5 to the first wiring part 21P and second wiring part 21N are cancelled. Further, in the second embodiment, compared with the comparative example, the voltages given from the frame 5 to the first wiring part 21P and second wiring part 21N are halved.

As described above, even in the present embodiment, at least a portion of the first detection-use wiring part (first wiring part 21P) and at least a portion of the second detection-use wiring part (second wiring part 21N) extend on the frame 5 alongside each other in the longitudinal direction of the frame 5 over 1/4 or more of the length of the frame 5. Accordingly, the same effects as those by the first embodiment are exhibited. For example, by reducing the difference between the charge given from the frame 5 to the first wiring part 21P and the charge given from the frame 5 to the second wiring part 21N, noise caused by the flexural deformation of the frame 5 can be reduced.

Further, in the present embodiment, the first detection-use wiring part (first wiring part 21P) has the first wiring body (wiring body 21a). The wiring body 21a in the first wiring part 21P is connected at one end to a first detecting electrode (detecting electrode 17B) and is connected at the other end to the other first detecting electrode (other detecting electrode 17B) or first detection-use terminal (see the terminal 13A in FIG. 6B) . The second detection-use wiring part (second wiring part 21N) has the second wiring body (wiring body 21a) and adjustment-use wiring 21b. The wiring body 21a in the second wiring part 21N is connected at one end to a second detecting electrode (detecting electrode 17A) and is connected at the other end to the other second detecting electrode (other detecting electrode 17A) or second detection-use terminal (see the terminal 13B in FIG. 6B) . The adjustment-use wiring 21b is connected at one end to the first detecting electrode 17A, the wiring body 21a in the second wiring part 21N or the terminal 13B, and is made the open end at the other end. At least a portion of the wiring body 21a in the first wiring part 21P and at least a portion of the adjustment-use wiring 21b in the second wiring part 21N extend on the frame 5 alongside each other in the longitudinal direction of the frame 5.

Accordingly, for example, as understood from a comparison of the comparative example (FIG. 6A), the first embodiment (FIG. 5A) , and the present embodiment (FIG. 7A) , in the present embodiment, relative to comparative example, the necessity of changing the position of the wiring body 21a and/or connection relationships between various electrodes and the plurality of terminals 13 is reduced. Accordingly, for example, noise caused by the flexural deformation of the frame 5 can be reduced by a simple method of adding the adjustment-use wiring 21b without making a big change with respect to the initial design. Further, for example, the length of the adjustment-use wiring 21b may be any length (from another viewpoint, the position of the open end may be any position), therefore the length of the adjustment-use wiring 21b can be adjusted based on the measured value of the noise caused by the flexural deformation of the frame 5 and the effect of reduction of noise can be improved.

Further, in the present embodiment, in the first detection-use wiring part (first wiring part 21P), the portion which extends on the frame 5 in the longitudinal direction of the frame 5 extends from the root side of the detecting arm 9 to only the first portion 5a side. In the second detection-use wiring part (second wiring part 21N), the portion which extends on the frame 5 in the longitudinal direction of the frame 5 extends from the root side of the detecting arm 9 to both of the first portion 5a side and second portion 5b side.

In this case, for example, the charge generated in any of the first portion 5a and second portion 5b can escape through the detection-use wiring part 21 to the external portion. Accordingly, the probability of formation of an unintended electric field on the periphery of the detecting arm 9 or the driving arms 7 by the charges in the first portion 5a and second portion 5b can be lowered. Further, for example, compared with a mode where the first wiring part 21P and the second wiring part 21N extend to only the first portion 5a side (first embodiment), it is easy to make the area of the detection-use wiring part 21 positioned in the first portion 5a and the area of the detection-use wiring part 21 positioned in the second portion 5b closer. As a result, for example, it is easy to make the influences of the detection-use wiring part 21 exhibited upon the rigidity of the frame 5 closer to each other between the first portion 5a and the second portion 5b.

### (Supplementation of Explanation of First Embodiment)

In the first embodiment, unlike the second embodiment, at least a portion of the first wiring body (wiring body 21a in the first wiring part 21P) and at least a portion of the second wiring body (wiring body 21a in the second wiring part 21N) extend on the frame 5 alongside each other in the longitudinal direction of the frame 5.

In this case, for example, the noise caused by the flexural deformation of the frame 5 is reduced due to the configurations of the wiring bodies 21a by themselves, therefore the areas of the detection-use wiring parts 21 on the frame 5 are easily reduced.

Further, in the first embodiment, the first detection-use wiring part (first wiring part 21P) is positioned in at least the first portion 5a between the first portion 5a and the second portion 5b. The second detection-use wiring part (second wiring part 21N) is positioned in at least the first portion 5a between the first portion 5a and the second portion 5b. The difference between the first length (LP=La-0) obtained by subtracting the length (0) of the first wiring part 21P in the second portion 5b from the length (La) of the first wiring part 21P in the first portion 5a and the second length (LN=La-0) obtained by subtracting the length (0) of the second wiring part 21N in the second portion 5b from the length (La) of the second wiring part 21N in the first portion 5a is half or less of the length La in the first portion 5a (0).

Accordingly, as already explained, in the first embodiment, noise caused by the flexural deformation of the frame 5 can be reduced not only relative to the comparative example, but also relative to the second embodiment. The length of the detection-use wiring part 21 in the above explanation may be made for example the length on the center line of the detection-use wiring part 21. Further, it may include not only the length of extension in the x-axis direction, but also the length of extension in the y-axis direction. As already explained, by complexity of the detection-use wiring parts 21 at the periphery of the root of the detecting arm 9, in the comparative example (FIG. 6A) as well, sometimes the difference of the first length LP and the second length LN is unintentionally reduced. However, due to the reduction due to such complexity, the difference may not become half of the length La or less.

Further, in the first embodiment, in both of the first detection-use wiring part (first wiring part 21P) and the second detection-use wiring part (second wiring part 21N) , the portions which extend on the frame 5 in the longitudinal direction of the frame 5 extend from the root side of the detecting arm 9 to only the first portion 5a side.

In this case, for example, the number of the adjustment-use wirings 21b can be decreased or the adjustment-use wirings 21b can be eliminated. That is, by a simple configuration, the difference between the first length LP and the second length LN can be made half of the length La or less.

In the second embodiment and third embodiment which will be explained later, unlike the first embodiment, the terminal 13B is one example of the second (or first) detection-use terminal (see FIG. 6B). The terminals 13C and 13D are examples of the excitation-use terminals.

### [Third Embodiment]

FIG. 7B is a view (top view) corresponding to FIG. 5A which schematically shows the detection-use wiring parts 21 in a sensor element 301 according to a third embodiment. The bottom view of the sensor element 301 is the same as FIG. 6B according to the comparative example.

In the second embodiment, between the first wiring part 21P and the second wiring part 21N, only the second wiring part 21N was provided with the adjustment-use wiring 21b. Contrary to this, in the present embodiment, the adjustment-use wiring 21b is provided also in the first wiring part 21P. Further, in the present embodiment, a difference (0-0=0) between a first length (LP=La-La=0) obtained by subtracting the length of the first wiring part 21P in the second portion 5b (length La of the adjustment-use wiring 21b) from the length of the first wiring part 21P in the first portion 5a (length La of the wiring body 21a) and a second length (LN=La-La=0) obtained by subtracting the length of the second wiring part 21N in the second portion 5b (length La of the wiring body 21a) from the length of the second wiring part 21N in the first portion 5a (length La of the adjustment-use wiring 21b) is half or less of the length La in the first portion 5a.

As described above, in the present embodiment as well, in the same way as the first and second embodiments, at least a portion of the first detection-use wiring part (first wiring part 21P) and at least a portion of the second detection-use wiring part (second wiring part 21N) extend on the frame 5 alongside each other over 1/4 or more of the length of the frame 5 in the longitudinal direction of the frame 5. Accordingly, the same effects as those by the other embodiments are exhibited. For example, by reducing the difference between the charge given from the frame 5 to the first wiring part 21P and the charge given from the frame 5 to the second wiring part 21N, noise caused by the flexural deformation of the frame 5 can be reduced.

Further, in the present embodiment, in the same way as the second embodiment, at least a portion of the wiring body 21a in one of the first wiring part 21P and the second wiring part 21N and at least a portion of the adjustment-use wiring 21b in the other of the first wiring part 21P and the second wiring part 21N extend on the frame 5 alongside each other in the longitudinal direction of the frame 5. Accordingly, for example, in the same way as the second embodiment, by a simple method of adding the adjustment-use wiring 21b to the comparative example (from another viewpoint, the initial design), noise caused by the flexural deformation of the frame 5 can be reduced. On the other hand, in the present embodiment, in the same way as the first embodiment, the difference between the first length LP and the second length LN is half or less of the length La in the first portion 5a. Accordingly, noise caused by the flexural deformation of the frame 5 is reduced more easily than the second embodiment.

From another viewpoint, in both of the first detection-use wiring part (first wiring part 21P) and the second detection-use wiring part (second wiring part 21N), the portion which extends on the frame 5 in the longitudinal direction of the frame 5 extends from the root side of the detecting arm 9 toward both of the first portion 5a side and the second portion 5b side.

In this case, for example, in the same way as the first embodiment, the difference between the first length LP and the second length LN described above can be made half of the length La or less. On the other hand, in the same way as the second embodiment, for example, the charge generated in any of the first portion 5a and second portion 5b can escape through the detection-use wiring part 21 to the external portion. Further, for example, it is easy to make the area of the detection-use wiring part 21 positioned in the first portion 5a and the area of the detection-use wiring part 21 positioned in the second portion 5b closer to each other.

### [Fourth Embodiment]

FIG. 8 is a plan view showing the configuration of a sensor element 401 according to a fourth embodiment. In this view, however, illustration of the conductive layers provided on the surface of the sensor element 401 is basically omitted.

### (Configuration of Sensor Element)

A piezoelectric body 403 in the sensor element 401 first of all includes a shape like two piezoelectric bodies 3 of the first embodiment combined. That is, the piezoelectric body 403 has two units 404 (404A and 404B) . Each unit 404 has a frame 5 (5A or 5B) , at least pair of (two pairs in the present embodiment) driving arms 7 (7C to 7J) which extend from the frame 5 alongside each other in the y-axis direction, and a detecting arm 9 (9A or 9B).

The two units 404 are arranged so as to make the opposite sides to the direction of extension of the driving arms 7 and detecting arms 9 face each other. The distance between the two units 404 may be suitably set so that for example the frames 5A and 5B do not contact each other. The two units 404 for example have substantially the same shapes and sizes (shapes and sizes line symmetrical relative to a not shown symmetrical axis parallel to the x-axis).

Further, the piezoelectric body 3 in the first embodiment had the pair of mounting arms 11 as the portions supporting the frame 5 and as the portions provided with the terminals 13. Contrary to this, in the piezoelectric body 403, a mounting part 411 corresponding to the mounting arms 11, when viewed on a plane, has an inner frame 23 which supports the frames 5, projection portions 25 which project from the inner frame 23 to the outer side, and an outer frame 27 which is connected to the front ends of the projection portions 25. The plurality of terminals 13 are provided on the bottom surface of the outer frame 27.

The illustrated mounting part 411 are only one example of the mounting part supporting the two frames 5. The mounting part can have various shapes. For example, the outer frame 27 needs not be frame shaped, but may be shaped as a plurality of legs which extend in suitable directions while bending as well. The number of the projection portions 25 need not be two, but may be only one. The outer frame 27 and the projection portions 25 need not be provided, but the plurality of terminals 13 may be provided on the inner frame 23. In place of the mounting part 411, the two frames 5 may be supported by the same configurations as those of the pair of mounting arms 11 in the first embodiment.

As the plurality of terminals 13, six are provided in the example shown. Four among them, in the same way as the first embodiment, are connected to the excitation electrodes 15 which are divided into two sets from a viewpoint of potential and to the detecting electrodes 17 divided into the two sets from the viewpoint of potential. The remaining two are for example terminals given the reference potential which were referred to also in the first embodiment and are connected to the reference potential wiring 20. The six terminals 13 may be provided at suitable positions at the outer frame 27. The reference potential wiring 20 and the reference potential-use terminals 13 need not be provided either.

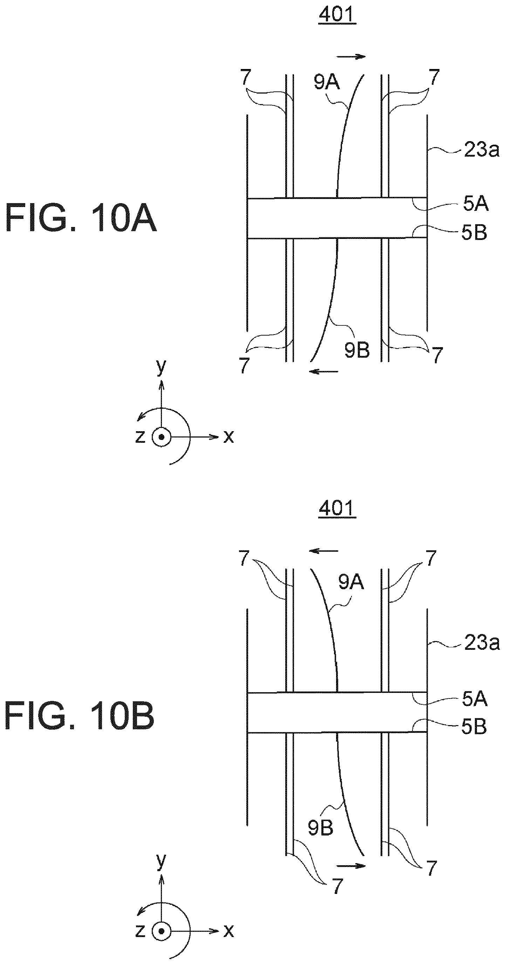

In contrast to the piezoelectric body 3 in the first embodiment having the pair of driving arms 7 for one frame 5, the unit 404 in the piezoelectric body 403 has two pairs of driving arms 7 with respect to one frame 5. As will be explained later (FIG. 10A and FIG. 10B), each two mutually neighboring driving arms 7 (two of 7C and 7D, two of 7E and 7F, two of 7G and 7H, and two of 7I and 7J) are supplied with voltages with the same phases so as to flex together to the same sides as each other in the x-axis direction. Accordingly, two mutually neighboring driving arms 7 may be grasped to correspond to one driving arm 7 in the first embodiment.

By dividing the driving arm 7 in the first embodiment into two in this way, for example, even if the lengths of the driving arms 7 are made short, the mass as the entireties of the driving arms 7 can be secured and in turn reduction of size and improvement of the detection sensitivity can both be achieved. A larger number of driving arms 7 than two pairs may be provided with respect to one frame as well. The shapes and dimensions of the two mutually neighboring driving arms 7 are for example substantially the same as each other. However, they may be different from each other as well. The piezoelectric body 403 for example has a substantially line symmetrical shape about a not shown symmetrical axis (detecting arm 9). The shapes and arrangements of the plurality of driving arms 7 are also substantially line symmetrical.

The configurations and connection relationships of the excitation electrodes 15 and detecting electrodes 17 in each unit 404 in the sensor element 401 may be the same as those in the sensor element 1. As already explained, the two mutually neighboring driving arms 7 correspond to one driving arm 7 in the first embodiment and are supplied with voltages with the same phases as each other. Accordingly, between these two driving arms 7, the excitation electrodes 15A are rendered the same potentials as each other, and the excitation electrodes 15B are rendered the same potentials as each other. The excitation electrodes 15 which should become the same potential are for example connected to each other by the excitation-use wiring part 19.

The connection relationships of the excitation electrodes 15 and detecting electrodes 17 between the units 404 will be explained in the following explanation of the operation.

### (Operation of Angular Velocity Sensor)

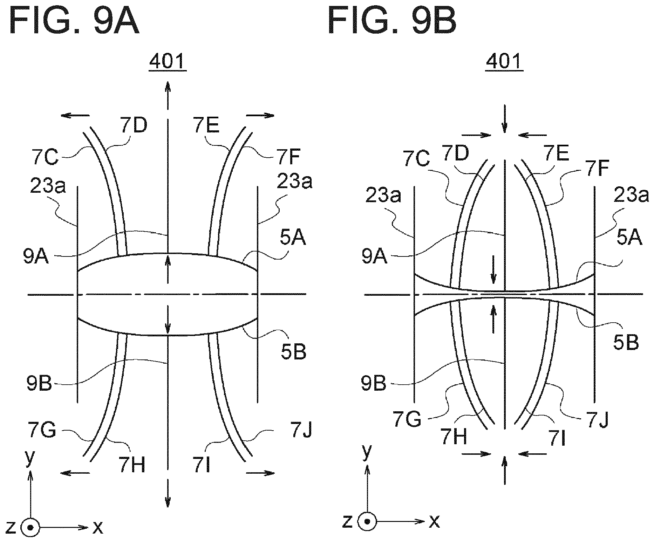

FIG. 9A and FIG. 9B are schematic plan views showing the excitation states of the piezoelectric body 403 in the fourth embodiment and correspond to FIG. 3A and FIG. 3B for the first embodiment. In these schematic views, in the mounting part 411, only parts of the inner frame 23 (parts of the pair of lateral side portions 23a) are shown.

The excitation in each unit 404 is basically the same as the excitation of the piezoelectric body 3 in the first embodiment. However, in each unit 404, the two mutually neighboring driving arms 7 are supplied with voltages with the same phases as each other so as to flex together to the same sides as each other, so correspond to one driving arm 7 in the piezoelectric body 3.

Between the two units 404, for example, voltages with the same phases are supplied so that the driving arms 7 which are positioned on the same side (positive side or negative side) in the x-axis direction relative to the detecting arm 9 bend to the same side in the x-axis direction. Accordingly, the frames 5A and 5B flex to inverse directions to each other. Further, the detecting arms 9A and 9B displace to inverse directions to each other.

For application of voltages as described above, for example, in each of the driving arms 7 which are positioned on the same side in the x-axis direction relative to the detecting arm 9 (7C, 7D, 7G, and 7H, or 7E, 7F, 7I, and 7J), the excitation electrodes 15A are rendered the same potentials as each other and the excitation electrodes 15B are rendered the same potentials as each other. The excitation electrodes 15 which should become the same potentials are for example connected to each other by the plurality of excitation-use wiring parts 19. Further, all excitation electrodes 15 are connected through the two among the six terminals 13 to the driving circuit 103 (FIG. 2B).

FIG. 10A and FIG. 10B are schematic plan views for explaining vibrations of the detecting arms 9 in the sensor element 401 and correspond to FIG. 4A and FIG. 4B for the first embodiment. In these views, illustration of deformations of the frames 5 and driving arms 7 is omitted.

As explained with reference to FIG. 9A and FIG. 9B, consider the states where the piezoelectric body 403 is vibrating. When the sensor element 401 is rotated about the z-axis in this state, in each unit 404, in the same way as the first embodiment, the detecting arm 9 vibrates in the x-axis direction due to the Coriolis force. At this time, the detecting arms 9A and 9B are vibrating with phases of displacement to inverse sides to each other in the y-axis direction, therefore they receive the Coriolis force at the same side relative the rotation direction about the z-axis. From another viewpoint, the detecting arms 9A and 9B vibrate so as to bend to inverse sides to each other in the x-axis direction.

In order to add the signals generated in such detecting arms 9A and 9B, for example, the detecting electrodes 17A in the detecting arm 9A and the detecting electrodes 17B in the detecting arm 9B are connected and the detecting electrodes 17B in the detecting arm 9A and the detecting electrodes 17A in the detecting arm 9B are connected. This connection is for example carried out by the plurality of detection-use wiring parts 21. Further, all detecting electrodes 17 are connected through two among the six terminals 13 to the detecting circuit 105 (FIG. 2B).

### (Detection-Use Wiring Parts)

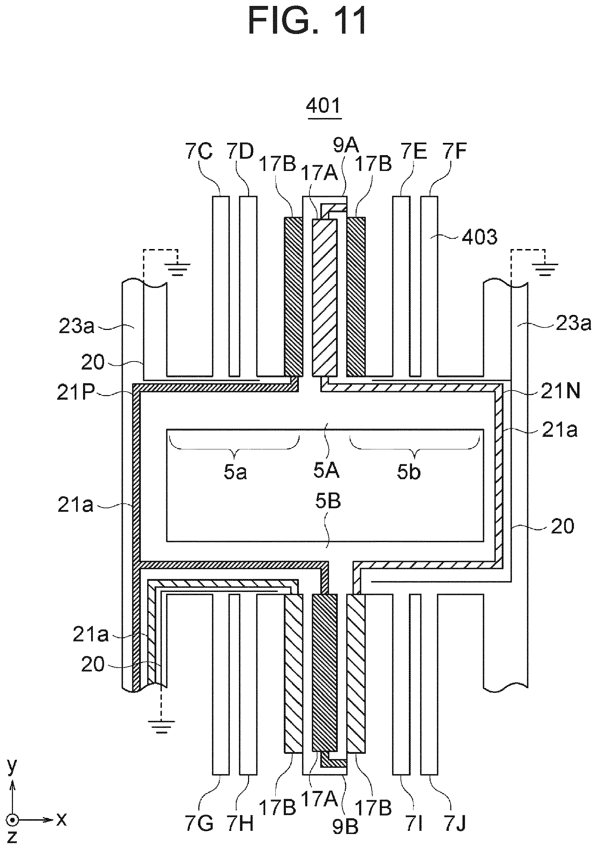

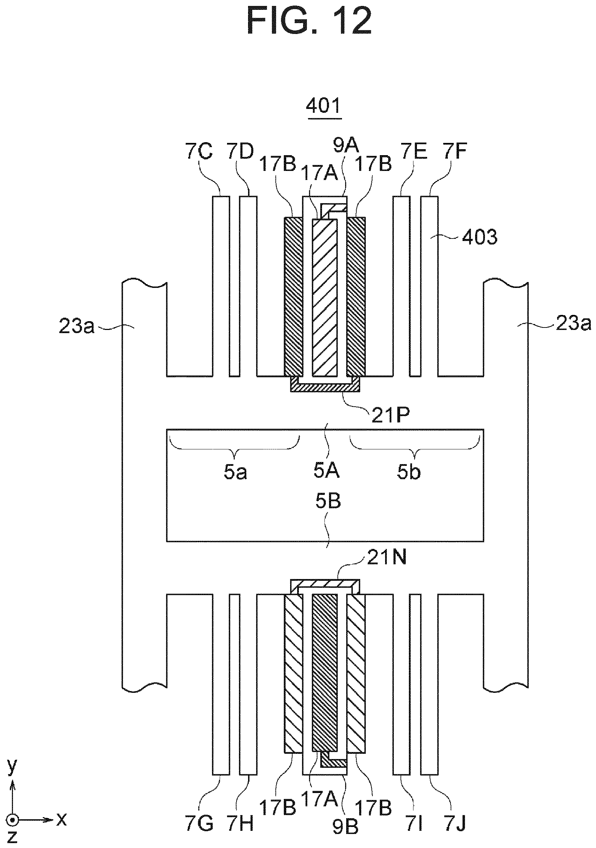

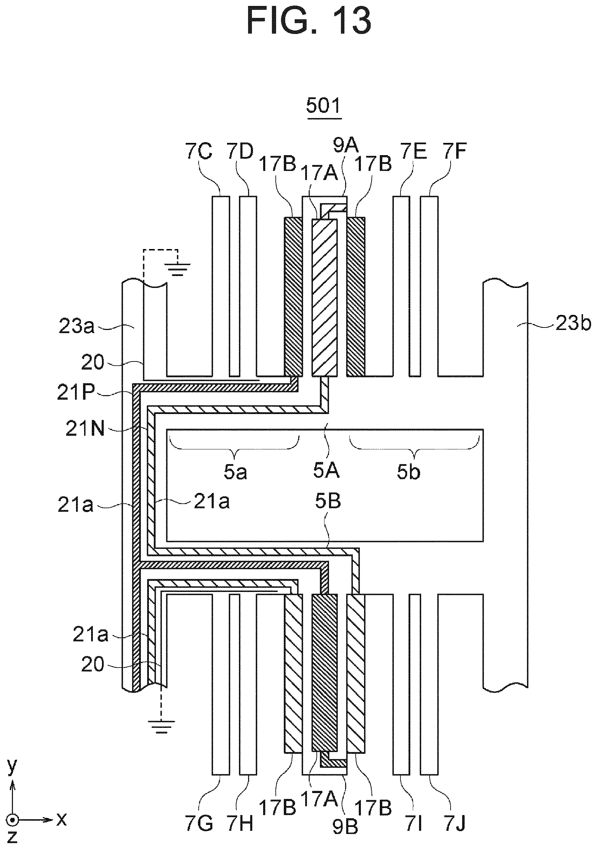

FIG. 11 is a top view schematically showing detection-use wiring parts 21 in the sensor element 401 and corresponds to FIG. 5A for the first embodiment. FIG. 12 is a bottom view schematically showing the detection-use wiring parts 21 seen through it from the upper part and corresponds to FIG. 5B for the first embodiment. However, in FIG. 11, unlike FIG. 5A, the positions of at least parts in the reference potential wiring 20 are indicated by solid lines. The same is true for the other drawings (FIG. 13 to FIG. 16) corresponding to FIG. 5A which will be explained later.

In the same way as the first embodiment, in each detecting arm 9, the detecting electrodes 17A are connected to each other and the detecting electrodes 17B are connected to each other. This connection, for example, in the same way as the first embodiment, is carried out at the front end or root side of each detecting arm 9.

Further, the detecting electrodes 17B on the detecting arm 9A and the detecting electrodes 17A on the detecting arm 9B are connected by the first wiring part 21P. The detecting electrodes 17A on the detecting arm 9A and the detecting electrodes 17B on the detecting arm 9B are connected by the second wiring part 21N.

More specifically, in the example shown, the first wiring part 21P has an wiring body 21a which extends from the detecting electrode 17B on the detecting arm 9A to the -x side in the frame 5A (its first portion 5a) and reaches the lateral side portion 23a. Further, the first wiring part 21P has an wiring body 21a which extends from the detecting electrodes 17A on the detecting arm 9B to the -x side in the frame 5B (its first portion 5a) and reaches the lateral side portion 23a. The above two wiring bodies 21a join and extend along the lateral side portion 23a. Although not particularly shown, the wiring body 21a after this joining runs from the inner frame 23, passes through the projection part 25, reaches the outer frame 27, and is connected to the terminal 13.

Further, in the example shown, the second wiring part 21N has an wiring body 21a which extends from the detecting electrodes 17A on the detecting arm 9A to the +x side in the frame 5A (its second portion 5b) and reaches the lateral side portion 23a. This wiring body 21a further extends in the +x side lateral side portion 23a to the frame 5B side, then extends to the -x side in the frame 5B (its second portion 5b), and is connected to the detecting electrode 17B on the detecting arm 9B. Further, the second wiring part 21N has an wiring body 21a which extends from the detecting electrode 17B on the detecting arm 9B to the -x side in the frame 5B (its first portion 5a) and reaches the lateral side portion 23a. This wiring body 21a, although not particularly shown, passes from the inner frame 23 through the projection part 25, reaches the outer frame 27, and is connected to the terminal 13.

Further, the portion in the first wiring part 21P which extends from the detecting electrodes 17A on the detecting arm 9B to the -x side in the frame 5B (its first portion 5a) and the portion in the second wiring part 21N which extends from the detecting electrode 17B on the detecting arm 9B to the -x side in the frame 5B (its first portion 5a) extend alongside each other. The length of the extension alongside is 1/4 or more (substantially 1/2 in the example shown) of the length of one frame 5. Accordingly, in the present embodiment as well, effects the same as those by the first embodiment are exhibited. For example, by reducing the difference between the charge which is given from the frame 5 to the first wiring part 21P and the charge given from the frame 5 to the second wiring part 21N, noise caused by the flexural deformation of the frame 5 can be reduced.

In more detail, in the present embodiment, in the same way as the first embodiment, the wiring bodies 21a in the first wiring part 21P and second wiring part 21N extend alongside each other in the frame 5. Further, in the present embodiment, in the same way as the second embodiment, one of the first wiring part 21P and second wiring part 21N (the first wiring part 21P) extends from the root side of the detecting arms 9 to only the first portion 5a side, and the other (second wiring part 21N) extends from the root side of the detecting arms 9 to both of the first portion 5a side and the second portion 5b side.

In the present embodiment, the first portions 5a in the two frames 5 have the same relative relationships as each other relative to the deformation of the portion which becomes the positive side of the polarization axis (x-axis) and the deformation of the portion which becomes the negative side. Accordingly, the charges generated in the first portions 5a in the two frames 5 are the same polarity and are equal in magnitude in many cases. The same is true for the second portions 5b. Accordingly, when considering the first length LP and second length LN explained above, they may be considered as the lengths of the first wiring part 21P and second wiring part 21N in the entireties of the two frames 5.

For example, in the present embodiment, the first length LP obtained by subtracting the length (0) of the first wiring part 21P in the second portions 5b from the length (2×La) of the first wiring part 21P in the first portions 5a becomes 2La-0=2La. The second length LN obtained by subtracting the length (2×La) of the second wiring part 21N in the second portions 5b from the length (La) of the second wiring part 21N in the first portions 5a becomes La-2La=-La. Accordingly, the difference of the two (LP-LN) becomes 2La-(-La)=3La.

On the other hand, as a comparative example, for example, concerning the second wiring part 21N, a configuration extending the wiring body 21a which is positioned in the +x side lateral side portion 23a to the projection part 25 and connecting this to the terminal 13 without providing the wiring body 21a which extends from the detecting electrode 17B on the detecting arm 9B to the -x side in the frame 5B (its first portion 5a) is conceivable. In this configuration, the first length LP is the same as that in the present embodiment. Further, the second length LP becomes -2La. Accordingly, the difference of the two (LP-LN) becomes 2La-(-2La)=4La.

It is seen from this fact that, in the present embodiment, compared with the comparative example described above, by provision of the wiring body 21a which extends from the detecting electrode 17B on the detecting arm 9B to the -x side in the frame 5B (its first portion 5a), the difference between the first length LP and the second length LN is reduced. That is, due to extension of the first wiring part 21P and the second wiring part 21N in the frame 5 alongside each other, reduction of noise can be confirmed.

In the comparative example as well, in actuality, due to the complexity of the detection-use wiring parts 21 on the root side of the detecting arms 9, there is a possibility of unintended reduction of the difference between the first length LP and the second length LN. However, the difference in this case is considered not to become shorter than 4La-La/2=7La/2.

### [Fifth Embodiment]

FIG. 13 is a top view schematically showing detection-use wiring parts 21 in a sensor element 501 according to a fifth embodiment and corresponds to FIG. 5A for the first embodiment. The bottom view of the sensor element 501 is the same as FIG. 12 according to the fourth embodiment.

The configurations of the detection-use wiring parts 21 in the sensor element 501, in short, are changed so that, in the second wiring part 21N in the fourth embodiment (FIG. 11), the wiring body 21a which extends from the detecting electrodes 17A on the detecting arm 9A, passes through the +x side lateral side portion 23a, and reaches the detecting electrode 17B on the detecting arm 9B passes through the -x side lateral side portion 23a. As a result, this wiring body 21a extends alongside the wiring body 21a in the first wiring part 21P which extends from the detecting electrode 17B on the detecting arm 9A and reaches the detecting electrodes 17A on the detecting arm 9B in the first portions 5a in the frames 5A and 5B.

Even in such a configuration, in the same way as the other embodiments, the first wiring part 21P and the second wiring part 21N extend alongside each other over 1/4 or more of the length of the frame 5, therefore the same effects as those by the first embodiment are exhibited. For example, the difference between the charge given from the frames 5 to the first wiring part 21P and the charge given from the frames 5 to the second wiring part 21N is reduced and noise caused by the flexural deformation of the frames 5 can be reduced.

In more detail, in the present embodiment, in the same way as the first embodiment, the wiring bodies 21a in the first wiring part 21P and second wiring part 21N extend alongside each other in the frames 5. Further, in the present embodiment, in the same way as the first embodiment, the two of the first wiring part 21P and the second wiring part 21N extend from the root side of the detecting arms 9 to only the first portion 5a side.

In the present embodiment, the first length LP obtained by subtracting the length (0) of the first wiring part 21P in the second portions 5b from the length (2×La) of the first wiring part 21P in the first portions 5a becomes 2La-0=2La. The second length LN obtained by subtracting the length (0) of the second wiring part 21N in the second portions 5b from the length (3La) of the second wiring part 21N in the first portions 5a becomes 3La-0=3La. Accordingly, the difference of the two (LP-LN) becomes 2La-3La=-La. The length (absolute value) is short compared with the difference (3La) between the first length LP and the second length LN in the fourth embodiment. That is, in the present embodiment, noise can be further reduced compared with the fourth embodiment.

In all of the present embodiment and sixth to eighth embodiments which will be explained later, the difference between the first length LP and the second length LN is shorter than that in the fourth embodiment. When considering the complexity of the detection-use wiring parts 21 on the root side of the detecting arms 9, from comparison with the fourth embodiment, the fifth to eighth embodiments may be said to be modes where the difference between the first length LP and the second length LN is 5La/2(=3La-La/2) or less. Further, the present embodiment may be a mode where the difference (absolute value) between the first length LP and the second length LN is 3La/2 or less.

In the present embodiment, the wiring body 21a in the second wiring part 21N which reaches the terminal 13 extends from the detecting electrode 17B on the detecting arm 9B to the -x side in the frame 5B and reaches the lateral side portion 23a and, here, extends toward the not shown projection part 25. However, the wiring body 21a may extend from the +x side detecting electrode 17B to the +x side and reach the lateral side portion 23a and extend toward the projection part 25 as well. In this case as well, the absolute value of the difference between the first length LP and the second length LN is La.

### [Sixth Embodiment]

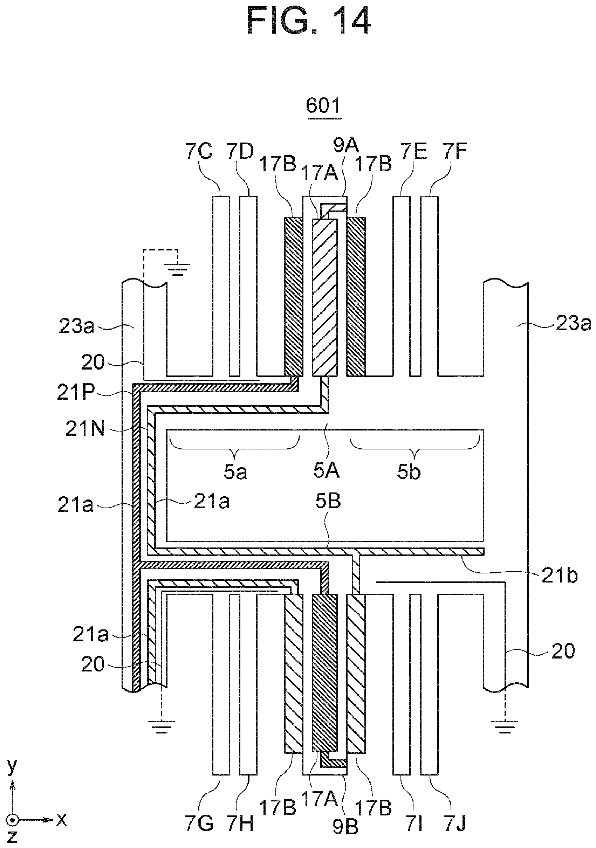

FIG. 14 is a top view schematically showing detection-use wiring parts 21 in a sensor element 601 according to a sixth embodiment and corresponds to FIG. 5A for the first embodiment. The bottom view of the sensor element 601 is the same as FIG. 12 according to the fourth embodiment.

The configurations of the detection-use wiring parts 21 in the sensor element 601, in short, add an adjustment-use wiring 21b which extends in the second portion 5b of the frame 5B in the second wiring part 21N in the fifth embodiment (FIG. 13) . In more detail, this adjustment-use wiring 21b is connected at one end to the wiring body 21a connecting the detecting electrodes 17A on the detecting arm 9A and the detecting electrode 17B on the detecting arm 9B and is made an open end at the other end.

The adjustment-use wirings 21b in the second embodiment (FIG. 7A) and third embodiment (FIG. 7B) were configured as portions extending alongside the other wiring parts (wiring bodies 21a) having different potentials. On the other hand, the adjustment-use wiring 21b in the present embodiment is not configured so as to extend alongside another wiring part having a different potential. The adjustment-use wiring 21b contributes to reduction of the difference between the first length LP and the second length LN. Due to this, for example, the difference between the charge given from the frame 5 to the first wiring part 21P and the charge given from the frame 5 to the second wiring part 21N is reduced, and noise caused by the flexural deformation of the frame 5 can be reduced.

Specifically, in the present embodiment, the first length LP obtained by subtracting the length (0) of the first wiring part 21P in the second portions 5b from the length (2×La) of the first wiring part 21P in the first portions 5a becomes 2La-0=2La. The second length LN obtained by subtracting the length (La) of the second wiring part 21N in the second portions 5b from the length (3La) of the second wiring part 21N in the first portions 5a becomes 3La-La=2La. Accordingly, the difference of the two (LP-LN) becomes 2La-2La=0. The length is short compared with the difference (La) between the first length LP and the second length LN in the fifth embodiment. That is, in the present embodiment, noise can be further reduced compared with the fifth embodiment.

As understood from the fifth embodiment (FIG. 13), there is a case where reduction of the difference between the first length LP and the second length LN to 0 is difficult by only adjustment of the position of the wiring body 21a. In such a case, as understood from the present embodiment, by providing the adjustment-use wiring 21b, the difference between the first length LP and the second length LN can be made 0.

When considering the complexity of the detection-use wiring parts 21 on the root side of the detecting arms 9, from comparison with the fifth embodiment, the present embodiment can be said to be a mode where the difference between the first length LP and the second length LN is La/2 or less. Further, in the present embodiment, in the same way as the first embodiment, the wiring bodies 21a in the first wiring part 21P and the second wiring part 21N extend in the frame 5 alongside each other. Further, in the present embodiment, in the same way as the second embodiment (FIG. 7A), the first wiring part 21P extends from the root side of the detecting arms 9 to only the first portion 5a side, and the second wiring part 21N extends from the root side of the detecting arms 9 to both of the first portion 5a side and second portion 5b side.

### [Seventh Embodiment]

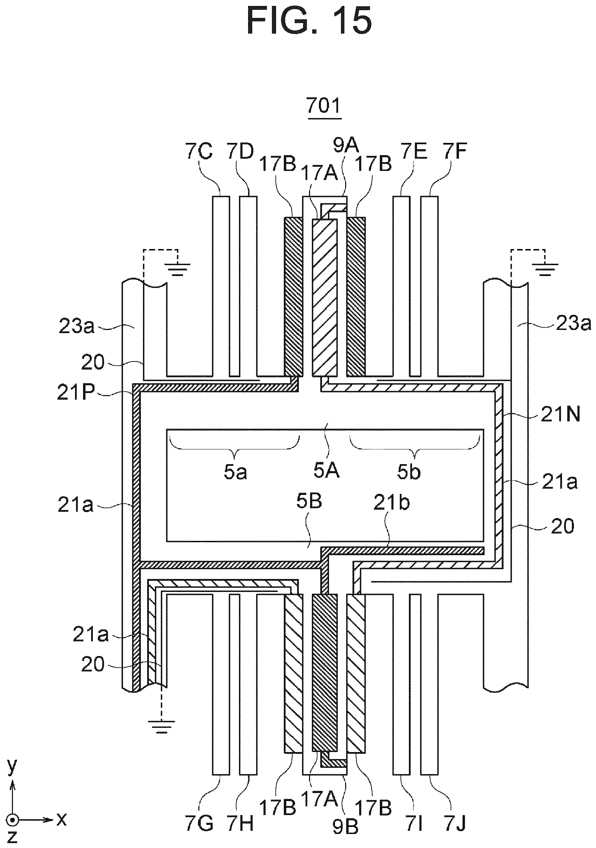

FIG. 15 is a top view schematically showing detection-use wiring parts 21 in a sensor element 701 according to a seventh embodiment and corresponds to FIG. 5A for the first embodiment. The bottom view of the sensor element 701 is the same as FIG. 12 according to the fourth embodiment.

The configurations of the detection-use wiring parts 21 in the sensor element 701, in short, add an adjustment-use wiring 21b which extends in the second portion 5b of the frame 5B to the first wiring part 21P in the fourth embodiment (FIG. 11) . In more detail, this adjustment-use wiring 21b is connected at one end to the wiring body 21a connecting the detecting electrode 17B on the detecting arm 9A and the detecting electrodes 17A on the detecting arm 9B and is made an open end at the other end.

By addition of the adjustment-use wiring 21b, in the present embodiment, compared with the fourth embodiment, the difference between the first length LP and the second length LN becomes short. Specifically, in the present embodiment, the first length LP obtained by subtracting the length (La) of the first wiring part 21P in the second portions 5b from the length (2×La) of the first wiring part 21P in the first portions 5a becomes 2La-La=La. The second length LN obtained by subtracting the length (2×La) of the second wiring part 21N in the second portions 5b from the length (La) of the second wiring part 21N in the first portions 5a becomes La-2La=-La. Accordingly, the difference of the two (LP-LN) becomes La-(-La)=2La. This length is short compared with the difference (3La) between the first length LP and the second length LN in the fourth embodiment. That is, in the present embodiment, noise can be further reduced compared with the fourth embodiment.

In the case where noise is reduced by the adjustment-use wiring 21b in this way, as explained in the second and third embodiments (FIG. 7A and FIG. 7B), the degree of change of design of the wiring body 21a etc. with respect to the initial design (here, FIG. 11) can be reduced.

In the present embodiment, in the same way as the first embodiment, the wiring bodies 21a in the first wiring part 21P and second wiring part 21N extend in the frame 5 alongside each other. Further, in the present embodiment, in the same way as the second and third embodiments (FIG. 7A and FIG. 7B), the wiring body 21a and the adjustment-use wiring 21b in the wiring parts (21P and 21N) having different potentials extend in the frame 5 alongside each other. Further, in the present embodiment, in the same way as the third embodiment, both of the first wiring part 21P and the second wiring part 21N extend from the root side of the detecting arms 9 to both of the first portion 5a side and the second portion 5b side.

### [Eighth Embodiment]

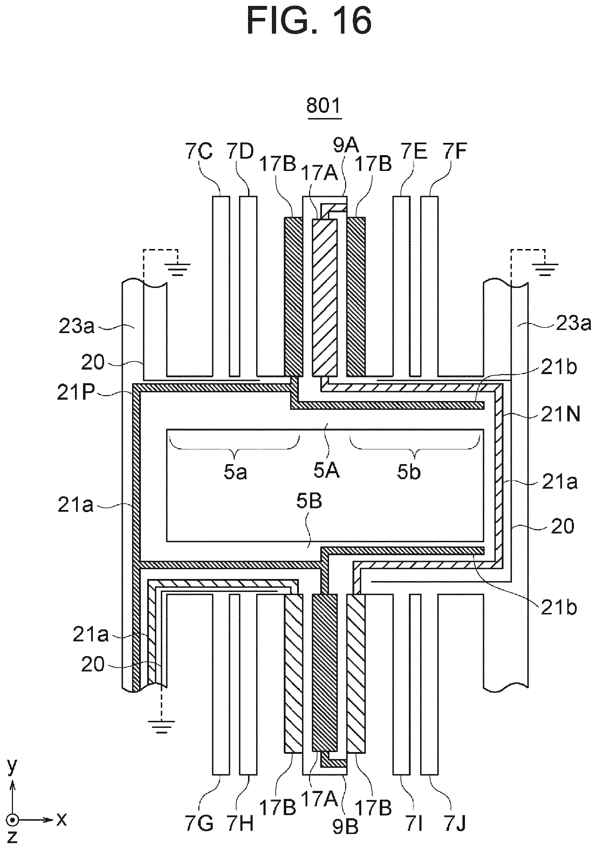

FIG. 16 is a top view schematically showing detection-use wiring parts 21 in a sensor element 801 according to an eighth embodiment and corresponds to FIG. 5A for the first embodiment. The bottom view of the sensor element 801 is the same as FIG. 12 according to the fourth embodiment.

The configurations of the detection-use wiring parts 21 in the sensor element 801, in short, add an adjustment-use wiring 21b which extends in the second portion 5b of the frame 5A to the first wiring part 21P in the seventh embodiment (FIG. 15) . In more detail, this adjustment-use wiring 21b is connected at one end to the wiring body 21a connecting the detecting electrode 17B on the detecting arm 9A and the detecting electrodes 17A on the detecting arm 9B and is made an open end at the other end.

By addition of this adjustment-use wiring 21b, in the present embodiment, compared with the seventh embodiment, the difference between the first length LP and the second length LN becomes short. Specifically, in the present embodiment, the first length LP obtained by subtracting the length (2×La) of the first wiring part 21P in the second portions 5b from the length (2×La) of the first wiring part 21P in the first portions 5a becomes 2La-2La=0. The second length LN obtained by subtracting the length (2×La) of the second wiring part 21N in the second portions 5b from the length (La) of the second wiring part 21N in the first portions 5a becomes La-2La=-La. Accordingly, the difference of the two (LP-LN) becomes 0- (-La) =La. This length is short compared with the difference (2La) between the first length LP and the second length LN in the seventh embodiment. That is, in the present embodiment, noise can be further reduced compared with the seventh embodiment.

### [Ninth Embodiment]

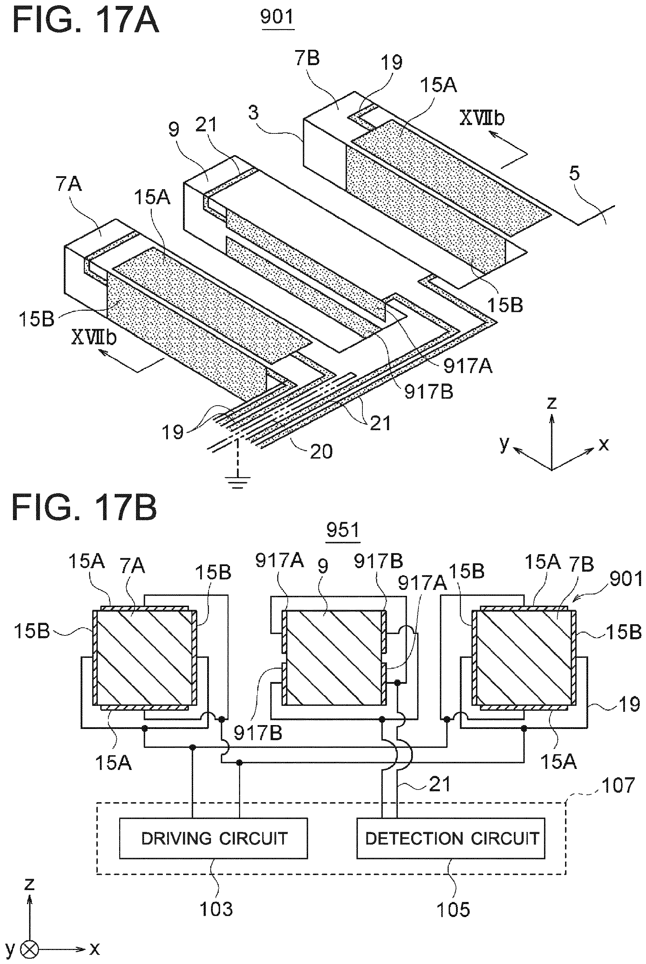

FIG. 17A is a perspective view the same as FIG. 2A which shows a portion of a sensor element 901 according to a ninth embodiment in an enlarged manner. FIG. 17B is a view the same as FIG. 2B which shows an angular velocity sensor 951 according to the ninth embodiment and includes a cross-sectional view corresponding to the XVIIb-XVIIb line in FIG. 17A.

In the angular velocity sensor 951 according to the second embodiment, in the same way as the angular velocity sensor 51 according to the first embodiment, by vibrating the pair of driving arms 7 in the x-axis direction, the frame 5 is made to flex (vibrate), and in turn the detecting arm 9 is made to displace (vibrate) in the y-axis direction. Further, the Coriolis force is made to directly act upon the detecting arm 9. However, in contrast to the angular velocity sensor 51 which detected the rotation about the z-axis, the angular velocity sensor 951 is made one detecting the rotation about the x-axis. Specifically, this is as follows.

The sensor element 901 has a piezoelectric body 3, a plurality of excitation electrodes 15, a plurality of detecting electrodes 917 (917A and 917B), a plurality of terminals 13 (see FIG. 1), and a plurality of excitation-use wiring parts 19 and a plurality of detection-use wiring parts 21. They may be basically made the same as those in the sensor element 1 in the first embodiment excluding the plurality of detecting electrodes 917 (and specific positions of the detection-use wiring parts 21 on the detecting arm 9 and on its periphery) . FIG. 1 may be grasped as a perspective view showing the sensor element 901.

In the present embodiment, however, the detecting arm 9 is designed to vibrate in the z-axis direction due to the Coriolis force unlike the first embodiment. Based on such difference, various dimensions may be different from those in the first embodiment.

A detecting electrode 917A is provided at the detecting arm 9 in each of a region on the positive side (for example more positive side than the center of the surface) in the z-axis direction in the surface facing the negative side in the x-axis direction and a region on the negative side (for example more negative side than the center of the surface) in the z-axis direction in the surface facing the positive side in the x-axis direction. A detecting electrode 917B is provided at the detecting arm 9 in each of a region on the negative side (for example more negative side than the center of the surface) in the z-axis direction in the surface facing the negative side in the x-axis direction and a region on the positive side (for example more positive side than the center of the surface) in the z-axis direction in the surface facing the positive side in the x-axis direction.

On each side surface of the detecting arm 9, the detecting electrodes 917A and 917B extend along the detecting arm 9 at a suitable interval so as not to be short-circuited with each other. The two detecting electrodes 917A are for example connected by the detection-use wiring part 21. Further, the two detecting electrodes 917B are for example connected by the detection-use wiring part 21.

In such an arrangement and connection relationships of the detecting electrodes 917, if the detecting arm 9 flexurally deforms in the z-axis direction, for example, electric fields parallel to the z-axis direction are generated. That is, on each side surface of the detecting arm 9, a voltage is generated between the detecting electrode 917A and the detecting electrode 917B. The directions of the electric fields are determined by the direction of the polarization axis and the direction of the flex (positive side or negative side in the z-axis direction) and are inverse to each other between the positive side portion and the negative side portion in the x-axis direction. The voltages (electric fields) are output to the detecting electrodes 917A and the detecting electrodes 917B. When the detecting arm 9 vibrates in the z-axis direction, the voltages are detected as AC voltage. The electric fields parallel to the z-axis direction may be dominant as described above. Otherwise, the ratio of the electric fields which are parallel to the x-axis direction and have inverse directions to each other between the positive side portion and the negative side portion in the z-axis direction is larger. In any case, voltage in accordance with the flexural deformation in the z-axis direction of the detecting arm 9 is generated between the detecting electrode 917A and the detecting electrode 917B.

Although not particularly shown, in the detecting arm 9, one or more via grooves (slits) which penetrate from the upper surface to the lower surface and extend along the longitudinal direction of the detecting arm 9 may be formed as well. Further, in each of a plurality of long portions divided by the via grooves, the detecting electrodes 917A and 917B may be arranged and connected as on the detecting arm 9 in the example shown. In this case, the plurality of detecting electrodes 917 become larger in overall areas, compared with the case where they are provided on only the outer side surface of the detecting arm 9. As a result, the charges generated on the detecting arm 9 can be efficiently extracted as electrical signals.

The plurality of detection-use wiring parts 21 connect the detecting electrodes 917 to each other as explained above. Further, the plurality of detection-use wiring parts 21 connect the detecting electrodes 917 divided into two sets from the viewpoint of potential and the two terminals 13. The plurality of detection-use wiring parts 21, in the same way as the embodiments hitherto, have the first wiring part 21P and second wiring part 21N. The arrangements of the first wiring part 21P and second wiring part 21N in the frame 5 may be made the same as any one shown in the embodiments hitherto.

### (Operation of Angular Velocity Sensor)

The excitation of the piezoelectric body 3 in the ninth embodiment is the same as that in the first embodiment. FIG. 3A and FIG. 3B may be grasped as views showing the excitation state of the piezoelectric body 3 in the ninth embodiment. Accordingly, the pair of driving arms 7 vibrate so as to become closer to or be separated from to each other in the x-axis direction, and the detecting arm 9 is displaced (vibrates) in the y-axis direction.

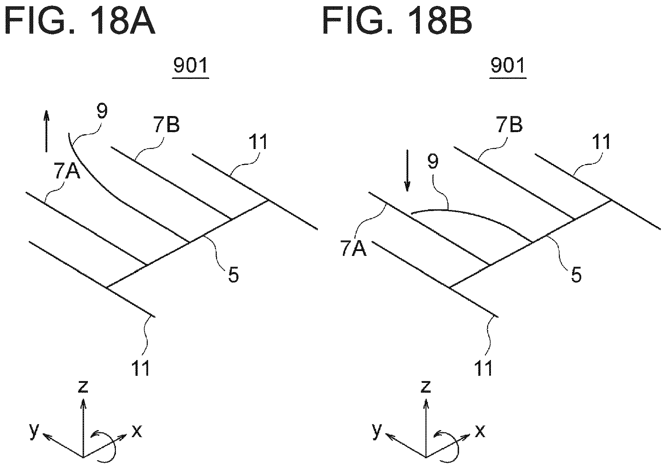

FIG. 18A and FIG. 18B are schematic perspective views for explaining vibration of the detecting arm 9 due to the Coriolis force. FIG. 18A and FIG. 18B correspond to the excitation states in FIG. 3A and FIG. 3B.

Consider the states where the piezoelectric body 3 vibrates as explained with reference to FIG. 3A and FIG. 3B. When the sensor element 901 is rotated about the x-axis in this state, the detecting arm 9 vibrates (displaces) in the y-axis direction, therefore it vibrates (deforms) in the direction (z-axis direction) perpendicular to the rotation axis (x-axis) and vibration direction (y-axis) due to the Coriolis force. The signal (voltage) generated according to this deformation is extracted by the detecting electrodes 17 as explained above. The larger the angular velocity, the larger the Coriolis force (in turn, the voltage of the signal detected). Due to this, the angular velocity is detected.

The present invention is not limited to the above embodiments and may be executed in various ways.

The plurality of embodiments explained above may be suitably combined. The configuration in the fourth embodiment etc. in which two mutually neighboring driving arms are excited with the same phases and vibrate as if they were one arm may be applied to the mode of the first embodiment etc. in which there is a single frame. Conversely, in a configuration in the fourth embodiment etc. in which there are two frames, only one pair of driving arms may be provided in each frame as well. Further, for example, the detecting electrodes in the ninth embodiment may be applied to a configuration in which there are two frames as well. In this case, the two detecting arms vibrate to inverse sides to each other in the z-axis direction due to the rotation about the x-axis. Accordingly, the detecting electrodes 917A on one detecting arm and the detecting electrodes 917B on the other detecting arm are connected.

In the fourth embodiment etc., the two units 404 were supported upon a common support part by making the opposite sides to the sides where the driving arms and detecting arms are extended outward face each other. However, the two units 404 may be supported upon a common support part by making the sides where the driving arms and detecting arms extend face each other as well (see FIG. 8 in Patent Literature 1). Further, the driving arms and detecting arm may extend from one frame to the two sides in the direction crossing the frame as well (see FIG. 9 in Patent Literature 1). Further, in the two units 404, the front ends of the driving arms may be connected to each other by making the sides where the driving arms and detecting arms extend outward face each other (see Patent Literature 2) .

Among the length, width, and thickness of the wiring part, the influence of the length is the largest on the magnitude of the charge given to the wiring part by the flexural deformation of the frame. Further, the width and thickness of the wiring part are restricted also according to the design values of the excitation electrodes and detecting electrodes and the accuracy of the process of forming the wiring parts. Accordingly, basically, as explained in the present embodiment, reduction of noise caused by the flexural deformation of the frame may be adjusted using the lengths of the wiring parts in the first portion and second portion of the frame as the standard. However, the widths and thicknesses in the first portion and second portion of the wiring parts may be adjusted as well.

The sensor element or angular velocity sensor may be configured as single parts of an MEMS (micro-electro mechanical system) . In this case, a piezoelectric body configuring the sensor element may be mounted on the substrate of the MEMS or the substrate of the MEMS may be configured by a piezoelectric body and the piezoelectric body of the sensor element may be configured by a portion of that.

### Reference Signs List

1... sensor element,3... piezoelectric body, 5... frame, 7... driving arm, 9... detecting arm, 13... terminal (excitation-use terminal, first detection-use terminal, or second detection-use terminal), 15... excitation electrode, 17A.. detecting electrode (first detecting electrode or second detecting electrode), 17B... detecting electrode (second detecting electrode or first detecting electrode), 19... excitation-use wiring part, 21P... first wiring part (first detection-use wiring part), 21N... second wiring part (second detection-use wiring part), 51... angular velocity sensor, 103... driving circuit, and 105... detection circuit.

## Claims

1. A sensor element (1) comprising:
a piezoelectric body (3) comprising
a frame (5) having an x-axis direction as a longitudinal direction in an orthogonal coordinate system xyz,
two driving arms (7) which mutually extend from the frame (5) in a y-axis direction at positions separated from each other in the x-axis direction, and
a detecting arm (9) extending from the frame (5) in the y-axis direction between the two driving arms (7) in the x-axis direction;
a plurality of excitation electrodes (15) which are located on the two driving arms (7) with arrangements exciting the two driving arms (7) in the x-axis direction;
one or more first detecting electrodes (17) and one or more second detecting electrodes (17) which are located on the detecting arm (9) with arrangements extracting mutually different polarity charges when the detecting arm (9) vibrates in the x-axis direction or z-axis direction;
two excitation-use terminals (13), a first detection-use terminal (13), and a second detection-use terminal (13);
a plurality of excitation-use wiring parts (19) which connects the plurality of excitation electrodes (15) and the two excitation-use terminals (13) with connection relationships where the two driving arms (7) bend to inverse sides to each other in the x-axis direction and vibrate with inverse phases when an AC voltage is supplied to the two excitation-use terminals (13);
a first detection-use wiring part (21P) which is connected to the one or more first detecting electrodes (17) and the first detection-use terminal (13); and
a second detection-use wiring part (21N) which is connected to the one or more second detecting electrodes (17) and the second detection-use terminal (13), wherein
the frame (5) includes a single detecting arm (9),
**characterized in that**
at least a portion of the first detection-use wiring part (21P) and at least a portion of the second detection-use wiring part (21N) extend on the frame (5) alongside each other over 1/4 or more of a length of the frame (5) in the longitudinal direction of the frame (5).

2. The sensor element (1) according to claim 1, wherein
the first detection-use wiring part (21P) comprises a first wiring body (21a) which is connected at one end to any of the one or more first detecting electrodes (17) and is connected at the other end to another one of the one or more first detecting electrodes (17) or the first detection-use terminal (13),
the second detection-use wiring part (21N) comprises a second wiring body (21a) which is connected at one end to any of the one or more second detecting electrodes (17) and is connected at the other end to another one of the one or more second detecting electrodes (17) or the second detection-use terminal (13), and
at least a portion of the first wiring body (21a) and at least a portion of the second wiring body (21a) extend on the frame (5) in the longitudinal direction of the frame.

3. The sensor element (1) according to claim 1 or 2, wherein
the first detection-use wiring part (21P) comprises a first wiring body (21a) which is connected at one end to any of the one or more first detecting electrodes (17A or 17B) and is connected at the other end to another one of the one or more first detecting electrodes (17A or 17B) or the first detection-use terminal (13),
the second detection-use wiring part (21N) comprises
a second wiring body (21a) which is connected at one end to any of the one or more second detecting electrodes (17) and is connected at the other end to another one of the one or more second detecting electrodes (17) or the second detection-use terminal (13), and
an adjustment-use wiring (21b) which is connected at one end to any of the one or more second detecting electrodes (17), the second wiring body (21a) or the second detection-use terminal (13) and is made an open end at the other end, and
at least a portion of the first wiring body (21a) and at least a portion of the adjustment-use wiring (21b) extend on the frame (5) in the longitudinal direction of the frame (5).

4. The sensor element (1) according to any one of claims 1 to 3, wherein
the piezoelectric body (3) comprises two units, each unit including its respective frame (5), its respective two driving arms (7), and its respective detecting arm (9),
in each of the two units, provision is made of the plurality of excitation electrodes (15), the one or more first detecting electrodes (17), and the one or more second detecting electrodes (17),
the plurality of excitation-use wiring parts (19), between the two units, connects the pluralities of excitation electrodes (15) in the two units in connection relationships where the driving arms (7) which are located on one side in the longitudinal direction of the frame (5) relative to the detecting arms (9) bend to the same side and where the driving arms (7) which are located on the other side in the longitudinal direction of the frame (5) relative to the detecting arms (9) bend to the same side,
the two frames (5) in the two units comprise
first portions (5a) closer to one side in the longitudinal direction of the two frames (5) than the detecting arms (9) and
second portions (5b) closer to the other side in the longitudinal direction of the two frames (5) than the detecting arms (9),
the first detection-use wiring part (21P) is located in at least the first portion (5a) between the first portions (5a) and the second portions (5b) in the two frames,
the second detection-use wiring part (21N) is located in at least the first portion (5a) between the first portions (5a) and the second portions (5b) in the two frames (5), and
an absolute value of a difference between a first length (LP) and a second length (LN) is 7/2 or less of a length of the first portion (5a) in one frame, the first length (LP) being obtained by subtracting a length of the first detection-use wiring part (21P) in the second portions (5b) from a length of the first detection-use wiring part (21P) in the first portions (5a), and the second length (LN) being obtained by subtracting a length of the second detection-use wiring part (21N) in the second portions (5b) from a length of the second detection-use wiring part (21N) in the first portions (5a).

5. The sensor element (1) according to claim 4, wherein the absolute value of the difference between the first length (LP) and the second length (LN) is a half or less of the length of the first portion (5a) in the one frame (5).

6. The sensor element (1) according to claim 4 or 5, wherein, in both of the first detection-use wiring part (21P) and the second detection-use wiring part (21N), portions in the two frames (5) which extend in the longitudinal direction of the two frames (5) extend from a root side of the detecting arms (9) to only a side where the first portions (5a) are located.

7. The sensor element (1) according to claim 4 or 5, wherein
portions in the first detection-use wiring parts (21P) which extend in the two frames (5) in the longitudinal direction of the two frames (5) extend from a root side of the detecting arms (9) to only a side where the first portions (5a) are located, and
portions in the second detection-use wiring parts (21N) which extend in the two frames (5) in the longitudinal direction of the two frames (5) extend from the root side of the detecting arms (9) to both of a side where the first portions (5a) are located and a side the second portions (5b) are located.

8. The sensor element (1) according to claim 4 or 5, wherein, in both of the first detection-use wiring part (21P) and the second detection-use wiring part (21N), portions which extend in the two frames (5) in the longitudinal direction of the frames (5) extend from a root side of the detecting arms (9) to both of a side where the first portions (5a) are located and a side where the second portions (5b) are located.

9. A sensor element comprising:
a sensor element (1) according to any one of claims 1 to 8;
a driving circuit (103) which supplies an AC voltage to the two excitation-use terminals (13), and
a detection circuit (105) which detects signals from the first detection-use terminal (13) and the second detection-use terminal (13).

## Patentansprüche

1. Sensorelement (1), umfassend:
einen piezoelektrischen Körper (3), umfassend
einen Rahmen (5) mit einer x-Achsenrichtung als Längsrichtung in einem orthogonalen Koordinatensystem xyz,
zwei Ansteuerarme (7), die sich von dem Rahmen (5) in Richtung der y-Achse an in Richtung der x-Achse voneinander getrennten Positionen erstrecken, und
einen Erfassungsarm (9), der sich von dem Rahmen (5) in Richtung der y-Achse zwischen den zwei Ansteuerarmen (7) in Richtung der x-Achse erstreckt;
eine Vielzahl von Erregungselektroden (15), die an den zwei Ansteuerarmen (7) angeordnet sind, mit Anordnungen, die die zwei Ansteuerarme (7) in Richtung der x-Achse erregen;
eine oder mehrere erste Erfassungselektroden (17) und eine oder mehrere zweite Erfassungselektroden (17), die auf dem Erfassungsarm (9) mit Anordnungen angeordnet sind, die gegenseitig Ladungen unterschiedlicher Polarität extrahieren, wenn der Erfassungsarm (9) in Richtung der x-Achse oder der z-Achse vibriert;
zwei Erregungsanschlüsse (13), einen ersten Erfassungsanschluss (13) und einen zweiten Erfassungsanschluss (13);
eine Vielzahl von Erregungsverdrahtungsteilen (19), die die Vielzahl von Erregungselektroden (15) und die zwei Erregungsanschlüsse (13) mit Verbindungsbeziehungen verbinden, bei denen sich die zwei Ansteuerarme (7) zu entgegengesetzten Seiten zueinander in x-Achsenrichtung biegen und mit entgegengesetzten Phasen vibrieren, wenn eine Wechselspannung an die zwei Erregungsanschlüsse (13) angelegt wird;
ein erstes Erfassungsverdrahtungsteil (21P), das mit der einen oder den mehreren ersten Erfassungselektroden (17) und dem ersten Erfassungsanschluss (13) verbunden ist; und
ein zweites Erfassungsverdrahtungsteil (21N), das mit der einen oder den mehreren zweiten Erfassungselektroden (17) und dem zweiten Erfassungsanschluss (13) verbunden ist, wobei
der Rahmen (5) einen einzelnen Erfassungsarm (9) enthält,
**dadurch gekennzeichnet, dass**
mindestens ein Abschnitt des ersten Erfassungsverdrahtungsteils (21P) und mindestens ein Abschnitt des zweiten Erfassungsverdrahtungsteils (21N) sich auf dem Rahmen (5) nebeneinander über 1/4 oder mehr einer Länge des Rahmens (5) in Längsrichtung des Rahmens (5) erstrecken.

2. Sensorelement (1) gemäß Anspruch 1, wobei
das erste Erfassungsverdrahtungsteil (21P) einen ersten Verdrahtungskörper (21a) umfasst, der an einem Ende mit einer der einen oder mehreren ersten Erfassungselektroden (17) verbunden ist und am anderen Ende mit einer anderen der einen oder mehreren ersten Erfassungselektroden (17) oder dem ersten Erfassungsanschluss (13) verbunden ist,
das zweite Erfassungsverdrahtungsteil (21N) einen zweiten Verdrahtungskörper (21a) umfasst, der an einem Ende mit einer der einen oder mehreren zweiten Erfassungselektroden (17) verbunden ist und am anderen Ende mit einer anderen der einen oder mehreren zweiten Erfassungselektroden (17) oder dem zweiten Erfassungsanschluss (13) verbunden ist, und
mindestens ein Abschnitt des ersten Verdrahtungskörpers (21a) und mindestens ein Abschnitt des zweiten Verdrahtungskörpers (21a) sich auf dem Rahmen (5) in Längsrichtung des Rahmens erstrecken.

3. Sensorelement (1) gemäß Anspruch 1 oder 2, wobei
das erste Erfassungsverdrahtungsteil (21P) einen ersten Verdrahtungskörper (21a) umfasst, der an einem Ende mit einer der einen oder mehreren ersten Erfassungselektroden (17A oder 17B) verbunden ist und am anderen Ende mit einer anderen der einen oder mehreren ersten Erfassungselektroden (17A oder 17B) oder dem ersten Erfassungsanschluss (13) verbunden ist,
der zweite Erfassungsverdrahtungsteil (21N) umfasst:
einen zweiten Verdrahtungskörper (21a), der an einem Ende mit einer der einen oder mehreren zweiten Erfassungselektroden (17) verbunden ist und am anderen Ende mit einer anderen der einen oder mehreren zweiten Erfassungselektroden (17) oder dem zweiten Erfassungsanschluss (13) verbunden ist, und
eine Einstellverdrahtung (21b), die an einem Ende mit einer der einen oder mehreren zweiten Erfassungselektroden (17), dem zweiten Verdrahtungskörper (21a) oder dem zweiten Erfassungsanschluss (13) verbunden ist und an dem anderen Ende ein offenes Ende aufweist, und
mindestens ein Abschnitt des ersten Verdrahtungskörpers (21a) und mindestens ein Teil der Einstellverdrahtung (21b) sich auf dem Rahmen (5) in Längsrichtung des Rahmens (5) erstrecken.

4. Sensorelement (1) gemäß einem der Ansprüche 1 bis 3, wobei
der piezoelektrische Körper (3) zwei Einheiten umfasst, wobei jede Einheit ihren jeweiligen Rahmen (5), ihre jeweiligen zwei Ansteuerarme (7) und ihren jeweiligen Erfassungsarm (9) enthält,
in jeder der zwei Einheiten die Vielzahl von Erregungselektroden (15), die eine oder die mehreren ersten Erfassungselektroden (17) und die eine oder die mehreren zweiten Erfassungselektroden (17) vorgesehen sind,
die Vielzahl von Erregungsverdrahtungsteilen (19) zwischen den zwei Einheiten die Vielzahl von Erregungselektroden (15) in den zwei Einheiten in Verbindungsbeziehungen verbindet, wobei die Ansteuerarme (7), die auf einer Seite in Längsrichtung des Rahmens (5) relativ zu den Erfassungsarmen (9) angeordnet sind, zur gleichen Seite gebogen sind und wobei die Ansteuerarme (7), die auf der anderen Seite in Längsrichtung des Rahmens (5) relativ zu den Erfassungsarmen (9) angeordnet sind, zur gleichen Seite gebogen sind,
die zwei Rahmen (5) in den zwei Einheiten Folgendes umfassen:
erste Abschnitte (5a), die in Längsrichtung der zwei Rahmen (5) näher an einer Seite als die Erfassungsarme (9) liegen und
zweite Abschnitte (5b), die in Längsrichtung der zwei Rahmen (5) näher an der anderen Seite als die Erfassungsarme (9) liegen,
der erste Erfassungsverdrahtungsteil (21P) in mindestens dem ersten Abschnitt (5a) zwischen den ersten Abschnitten (5a) und den zweiten Abschnitten (5b) in den zwei Rahmen angeordnet ist,
das zweite Erfassungsverdrahtungsteil (21N) in mindestens dem ersten Abschnitt (5a) zwischen den ersten Abschnitten (5a) und den zweiten Abschnitten (5b) in den zwei Rahmen (5) angeordnet ist, und
ein Absolutwert einer Differenz zwischen einer ersten Länge (LP) und einer zweiten Länge (LN) 7/2 oder weniger einer Länge des ersten Abschnitts (5a) in einem Rahmen beträgt, wobei die erste Länge (LP) durch Subtraktion einer Länge des ersten Erfassungsverdrahtungsteils (21P) in den zweiten Abschnitten (5b) von einer Länge des ersten Erfassungsverdrahtungsteils (21P) in den ersten Abschnitten (5a) erhalten wird, und die zweite Länge (LN) durch Subtraktion einer Länge des zweiten Erfassungsverdrahtungsteils (21N) in den zweiten Abschnitten (5b) von einer Länge des zweiten Erfassungsverdrahtungsteils (21N) in den ersten Abschnitten (5a) erhalten wird.

5. Sensorelement (1) gemäß Anspruch 4, wobei der Absolutwert der Differenz zwischen der ersten Länge (LP) und der zweiten Länge (LN) die Hälfte oder weniger der Länge des ersten Abschnitts (5a) in dem einen Rahmen (5) beträgt.

6. Sensorelement (1) gemäß Anspruch 4 oder 5, wobei sowohl in dem ersten Erfassungsverdrahtungsteil (21P) als auch in dem zweiten Erfassungsverdrahtungsteil (21N) Abschnitte in den zwei Rahmen (5), die sich in Längsrichtung der zwei Rahmen (5) erstrecken, von einer Ursprungsseite der Erfassungsarme (9) nur zu einer Seite verlaufen, an der sich die ersten Abschnitte (5a) befinden.

7. Sensorelement (1) gemäß Anspruch 4 oder 5, wobei
Abschnitte in den ersten Erfassungsverdrahtungsteilen (21P), die sich in den zwei Rahmen (5) in Längsrichtung der zwei Rahmen (5) erstrecken, sich von einer Ursprungsseite der Erfassungsarme (9) nur zu einer Seite erstrecken, an der sich die ersten Abschnitte (5a) befinden, und
Abschnitte in den zweiten Erfassungsverdrahtungsteilen (21N), die sich in den zwei Rahmen (5) in Längsrichtung der zwei Rahmen (5) erstrecken, sich von der Ursprungsseite der Erfassungsarme (9) sowohl zu einer Seite, auf der sich die ersten Abschnitte (5a) befinden, als auch zu einer Seite, auf der sich die zweiten Abschnitte (5b) befinden, erstrecken.

8. Sensorelement (1) gemäß Anspruch 4 oder 5, wobei sich sowohl in dem ersten Erfassungsverdrahtungsteil (21P) als auch in dem zweiten Erfassungsverdrahtungsteil (21N) Abschnitte, die sich in den zwei Rahmen (5) in Längsrichtung der Rahmen (5) erstrecken, von einer Ursprungsseite der Erfassungsarme (9) zu sowohl einer Seite, an der sich die ersten Abschnitte (5a) befinden, als auch einer Seite, an der sich die zweiten Abschnitte (5b) befinden, erstrecken.

9. Sensorelement, umfassend:
ein Sensorelement (1) gemäß einem der Ansprüche 1 bis 8;
eine Ansteuerschaltung (103), die eine Wechselspannung an die zwei Erregungsanschlüsse (13) anlegt, und
eine Erfassungsschaltung (105), die Signale aus dem ersten Erfassungsanschluss (13) und dem zweiten Erfassungsanschluss (13) erfasst.

## Revendications

1. Élément de capteurs (1) comprenant :
un corps piézoélectrique (3) comprenant
un cadre (5) ayant une direction d'axe x comme direction longitudinale dans un système de coordonnées orthogonales xyz,
deux bras d'entraînement (7) qui s'étendent mutuellement à partir du cadre (5) dans la direction d'axe y à des positions séparées l'une de l'autre dans la direction d'axe x, et
un bras de détection (9) s'étendant à partir du cadre (5) dans la direction d'axe y entre les deux bras d'entraînement (7) dans la direction d'axe x ;
une pluralité d'électrodes d'excitation (15) qui sont situées sur les deux bras d'entraînement (7) avec des dispositions excitant les deux bras d'entraînement (7) dans la direction d'axe x ;
une ou plusieurs premières électrodes de détection (17) et une ou plusieurs secondes électrodes de détection (17) qui sont situées sur le bras de détection (9) avec des agencements extrayant des charges de polarité mutuellement différentes lorsque le bras de détection (9) vibre dans la direction d'axe x ou dans la direction d'axe z ;
deux bornes d'excitation-utilisation (13), une première borne de détection-utilisation (13) et une seconde borne de détection-utilisation (13) ;
une pluralité de parties de câblage d'excitation-utilisation (19) qui connecte la pluralité d'électrodes d'excitation (15) et les deux bornes d'excitation-utilisation (13) avec des relations de connexion où les deux bras d'entraînement (7) se plient à l'inverse l'un de l'autre dans la direction d'axe x et vibrent avec des phases inverses lorsqu'une tension alternative est fournie aux deux bornes d'excitation-utilisation (13) ;
une première partie de câblage de détection-utilisation (21P) qui est connectée à la ou aux premières électrodes de détection (17) et à la première borne de détection-utilisation (13) ; et
une seconde partie de câblage de détection-utilisation (21N) qui est connectée à la ou aux secondes électrodes de détection (17) et à la seconde borne de détection-utilisation (13),
le cadre (5) comprenant un bras de détection (9) unique,
**caractérisé en ce que**
au moins une portion de la première partie de câblage de détection-utilisation (21P) et au moins une portion de la seconde partie de câblage de détection-utilisation (21N) s'étendent sur le cadre (5) l'une à côté de l'autre sur 1/4 ou plus d'une longueur du cadre (5) dans la direction longitudinale du cadre (5).

2. Élément de capteur (1) selon la revendication 1,
la première partie de câblage de détection-utilisation (21P) comprenant un premier corps de câblage (21a) qui est connecté au niveau d'une extrémité à l'une quelconque de la ou des premières électrodes de détection (17) et qui est connecté au niveau de l'autre extrémité à une autre de la ou des premières électrodes de détection (17) ou à la première borne de détection-utilisation (13),
la seconde partie de câblage de détection-utilisation (21N) comprenant un second corps de câblage (21a) qui est connecté au niveau d'une extrémité à l'une quelconque de la ou des secondes électrodes de détection (17) et qui est connecté au niveau de l'autre extrémité à une autre de la ou des secondes électrodes de détection (17) ou à la seconde borne de détection-utilisation (13), et
au moins une portion du premier corps de câblage (21a) et au moins une portion du second corps de câblage (21a) s'étendant sur le cadre (5) dans la direction longitudinale du cadre.

3. Élément de capteur (1) selon la revendication 1 ou 2,
la première partie de câblage de détection-utilisation (21P) comprenant un premier corps de câblage (21a) qui est connecté au niveau d'une extrémité à l'une quelconque de la ou des premières électrodes de détection (17A ou 17B) et qui est est connecté au niveau de l'autre extrémité à une autre de la ou des premières électrodes de détection (17A ou 17B) ou à la première borne de détection-utilisation (13),
la seconde partie de câblage de détection-utilisation (21N) comprenant
un second corps de câblage (21a) qui est connecté au niveau d'une extrémité à l'une de la ou des secondes électrodes de détection (17) et qui est connecté au niveau de l'autre extrémité à une autre de la ou des secondes électrodes de détection (17) ou à la seconde borne de détection-utilisation (13), et
un câblage d'ajustement-utilisation (21b) qui est connecté au niveau d'une extrémité à l'un quelconque de la ou des secondes électrodes de détection (17), au second corps de câblage (21a) ou à la seconde borne de détection-utilisation (13) et qui a une extrémité ouverte au niveau de l'autre extrémité, et
au moins une portion du premier corps de câblage (21a) et au moins une portion du câblage d'ajustement-utilisation (21b) s'étendant sur le cadre (5) dans la direction longitudinale du cadre (5).

4. Élément capteur (1) selon l'une quelconque des revendications 1 à 3,
le corps piézoélectrique (3) comprenant deux unités, chaque unité comprenant son cadre (5) respectif, ses deux bras d'entraînement (7) respectifs et son bras de détection (9) respectif,
dans chacune des deux unités, la pluralité d'électrodes d'excitation (15), la ou les premières électrodes de détection (17), et la ou les secondes électrodes de détection (17) étant fournies,
la pluralité de parties de câblage d'excitation-utilisation (19), entre les deux unités, connectant les pluralités d'électrodes d'excitation (15) dans les deux unités dans des relations de connexion où les bras d'entraînement (7) qui sont situés d'un côté dans la direction longitudinale du cadre (5) par rapport aux bras de détection (9) se courbent du même côté et où les bras d'entraînement (7) qui sont situés de l'autre côté dans la direction longitudinale du cadre (5) par rapport aux bras de détection (9) se courbent du même côté,
les deux cadres (5) des deux unités comprenant
des premières portions (5a) plus proches d'un côté dans la direction longitudinale des deux cadres (5) que les bras de détection (9) et
des secondes portions (5b) plus proches de l'autre côté dans la direction longitudinale des deux cadres (5) que les bras de détection (9),
la première partie de câblage de détection-utilisation (21P) étant située dans au moins la première portion (5a) entre les premières portions (5a) et les secondes portions (5b) dans les deux cadres,
la seconde partie de câblage de détection-utilisation (21N) étant située dans au moins la première portion (5a) entre les premières portions (5a) et les secondes portions (5b) dans les deux cadres (5), et
une valeur absolue d'une différence entre une première longueur (LP) et une seconde longueur (LN) étant inférieure ou égale à 7/2 d'une longueur de la première portion (5a) dans un cadre, la première longueur (LP) étant obtenue en soustrayant une longueur de la première partie de câblage de détection-utilisation (21P) dans les secondes portions (5b) d'une longueur de la première partie de câblage de détection-utilisation (21P) dans les premières portions (5a), et la seconde longueur (LN) étant obtenue en soustrayant une longueur de la seconde partie de câblage de détection-utilisation (21N) dans les secondes portions (5b) d'une longueur de la seconde partie de câblage de détection-utilisation (21N) dans les premières portions (5a).

5. Élément de capteur (1) selon la revendication 4, la valeur absolue de la différence entre la première longueur (LP) et la seconde longueur (LN) étant inférieure ou égale à la moitié de la longueur de la première portion (5a) dans le cadre (5).

6. Élément de capteur (1) selon la revendication 4 ou 5, dans à la fois la première partie de câblage de détection-utilisation (21P) et la seconde partie de câblage de détection-utilisation (21N), les portions des deux cadres (5) qui s'étendent dans la direction longitudinale des deux cadres (5) s'étendant d'un côté racine des bras de détection (9) vers seulement un côté où les premières portions (5a) sont situées.

7. Élément de capteur (1) selon la revendication 4 ou 5,
des portions dans les premières parties de câblage de détection-utilisation (21P) qui s'étendent dans les deux cadres (5) dans la direction longitudinale des deux cadres (5) s'étendant d'un côté racine des bras de détection (9) vers seulement un côté où les premières portions (5a) sont situées, et
des portions dans les secondes parties de câblage de détection-utilisation (21N) qui s'étendent dans les deux cadres (5) dans la direction longitudinale des deux cadres (5) s'étendant du côté racine des bras de détection (9) vers à la fois un côté où les premières portions (5a) sont situées et un côté où les secondes portions (5b) sont situées.

8. Élément de capteur (1) selon la revendication 4 ou 5, dans à la fois la première partie de câblage de détection-utilisation (21P) et la seconde partie de câblage de détection-utilisation (21N), les portions qui s'étendent dans les deux cadres (5) dans la direction longitudinale des cadres (5) s'étendant d'un côté racine des bras de détection (9) vers à la fois un côté où les premières portions (5a) sont situées et à un côté où les secondes portions (5b) sont situées.

9. Élément de capteur comprenant :
un élément de capteur (1) selon l'une quelconque des revendications 1 à 8 ;
un circuit d'entraînement (103) qui fournit une tension alternative aux deux bornes d'excitation-utilisation (13), et
un circuit de détection (105) qui détecte les signaux provenant de la première borne de détection-utilisation (13) et de la seconde borne de détection-utilisation (13).
